# FASCICULE DE BREVET EUROPEEN

(11) **EP 3 714 233 B1**
(45) Date de publication et mention de la délivrance du brevet: **18.09.2024**
(21) Numéro de dépôt: 18819330.4
(22) Date de dépôt: 22.11.2018
(51) Int. Cl.: G01C 19/62, G01P 15/093, G04F 5/14

(54) **DISPOSITIF ET PROCÉDÉ D'INTERACTION ENTRE UN FAISCEAU LASER AGILE ET UNE TRANSITION ÉNERGÉTIQUE HYPERFINE D'UNE ESPÈCE CHIMIQUE**
VORRICHTUNG UND VERFAHREN ZUR INTERAKTION ZWISCHEN EINEM AGILEN LASERSTRAHL UND EINEM HYPERFEINEN ENERGIEÜBERGANG EINER CHEMISCHEN SPEZIES
DEVICE AND METHOD FOR INTERACTION BETWEEN AN AGILE LASER BEAM AND A HYPERFINE ENERGY TRANSITION OF A CHEMICAL SPECIES

(30) Priorité: 24.11.2017 FR 1761161
(43) Date de publication de la demande: 30.09.2020
(73) Titulaire: EXAIL, 78100 Saint-Germain-en-Laye (FR); Institut d'Optique Graduate School, 91127 Palaiseau (FR); Centre National de la Recherche Scientifique, 75016 Paris (FR); Université de Bordeaux, 33000 Bordeaux (FR)
(72) Inventeur: PORTE, Henri, 25770 Serres Les Sapins (FR); BATTELIER, Baptiste, 33170 Gradignan (FR)
(74) Mandataire: Jacobacci Coralis Harle
(86) Numéro de dépôt international: PCT/FR2018/052959
(87) Numéro de publication internationale: WO 2019/102157

(56) Documents cités:
- US-A1- 2017 264 070
- BATTELIER B ET AL: "Development of compact cold-atom sensors for inertial navigation", ARXIV.ORG, CORNELL UNIVERSITY LIBRARY, 201 OLIN LIBRARY CORNELL UNIVERSITY ITHACA, NY 14853, 9 May 2016 (2016-05-09), XP080700186, DOI: 10.1117/12.2228351

## Description

### DOMAINE TECHNIQUE AUQUEL SE RAPPORTE L'INVENTION

La présente invention concerne de manière générale le domaine des systèmes de manipulation d'espèces chimiques telles que des atomes, ions ou molécules par des faisceaux laser.

La présente invention trouve notamment des applications dans les systèmes interférométriques à atomes froids et à impulsions laser.

### ARRIERE-PLAN TECHNOLOGIQUE

La technologie dite à atomes froids repose sur le contrôle de la température et la manipulation de nuages d'atomes dans un espace sous ultra vide. La technologie à atomes froids permet la réalisation d'interféromètres à atomes cohérents. Ces interféromètres à atomes froids trouvent des applications en particulier dans les horloges atomiques pour la métrologie ultra-haute précision du temps, dans un gravimètre et/ou accéléromètre pour des mesures d'accélération et/ou dans un gyromètre pour des mesures de rotation. Les capteurs d'accélération ou de rotation embarqués forment des senseurs inertiels par rapport au référentiel auquel ils sont fixés.

La réalisation d'un interféromètre à atomes froids et à impulsions lumineuses est basée sur les interactions entre une ou plusieurs sources laser et des atomes dans un espace sous ultra vide. La source laser est en général configurée pour remplir successivement au moins cinq fonctions différentes correspondant aux étapes suivantes.

La première étape consiste à ralentir des atomes par des mécanismes d'absorption de photons dans un piège magnéto-optique. La deuxième étape vise à former une mélasse optique où les atomes se trouvent à une température plus basse permettant d'exploiter leur comportement en ondes d'atomes. La troisième étape est la réalisation d'un interféromètre à atomes froids et à impulsions lumineuses dans laquelle au moins trois faisceaux laser, séparés dans le temps ou dans l'espace, réalisent les fonctions de lames séparatrices et de miroirs pour les ondes d'atomes. La quatrième étape consiste à détecter l'état d'interférence des ondes d'atomes en sortie de l'interféromètre par fluorescence laser sur une raie d'absorption des atomes. La cinquième étape est l'opération de comptage du nombre total d'atomes pour normaliser les mesures interférométriques.

Ces étapes forment une séquence dont la durée totale est généralement inférieure à une seconde.

Toutes ces étapes sont réalisées par des manipulations des atomes dans leurs différents niveaux d'énergie reposant sur des interactions entre des faisceaux d'impulsions laser et les atomes. A cet effet, il existe différents systèmes de source laser qui permettent de caler successivement et très précisément la fréquence optique en fonction des différentes transitions d'énergie utilisées autour d'une longueur d'onde de transition caractéristique de l'espèce atomique considérée.

Un tel système de source laser doit être adapté pour générer une seule raie laser ou deux raies lasers simultanées, chacune de ces raies lasers commutant en fréquence optique jusqu'à cinq fois au cours d'une séquence dans une gamme spectrale de moins de 100 GHz autour de la fréquence optique de transition. Chaque commutation s'applique pour une durée comprise entre quelques centaines de microsecondes et quelques centaines de millisecondes. Un tel système laser accordable et commutable rapidement et très précisément en fréquence optique est aussi appelée source laser agile dans le présent document.

Dans le présent document, on entend par laser agile, un laser commutable et accordable en fréquence optique disposant d'un réglage ou un ajustement très fin d'au moins une fréquence optique située dans le domaine THz pour produire un décalage de la fréquence optique du faisceau laser, ce décalage ayant une amplitude maximum de quelques dizaines de GHz, ou, autrement dit, un ajustement très fin en longueur d'onde d'au plus une dizaine de picomètres par rapport à une longueur d'onde prédéterminée, par exemple de 800 nm.

Chaque commutation de fréquence optique correspond à un changement de valeur de longueur d'onde déterminé très précisément en fonction du spectre d'absorption de l'espèce atomique utilisée. On utilise généralement des atomes alcalins tels que des atomes de césium (Cs), de rubidium (Rb) et/ou de potassium (K). D'autre part, la puissance lumineuse générée sur chaque raie doit être très précisément contrôlée. De plus, en interférométrie atomique, la phase relative entre les deux fréquences optiques doit être parfaitement contrôlée. Enfin, la largeur spectrale du laser source doit conserver sa très grande finesse pendant toute la durée du processus.

Selon l'état de l'art, il est connu d'utiliser une source laser unique stable et d'appliquer une séquence de modulations électro-optiques externes à l'aide de signaux à des fréquences porteuses micro-onde de fréquences prédéterminées. Par exemple, la longueur d'onde cible est de 852.34 nm pour le césium, de 780.24 nm pour le rubidium et de 767 nm pour le potassium.

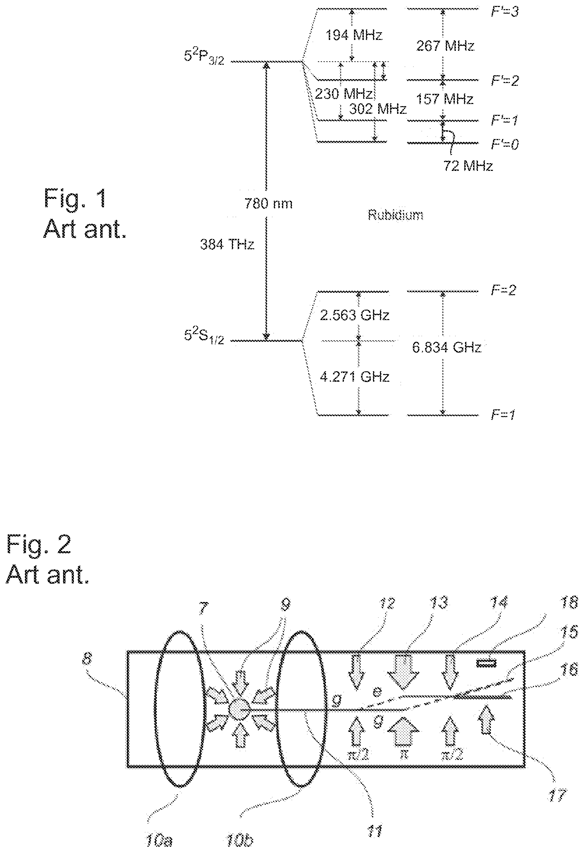

La figure 1 représente schématiquement les niveaux d'énergie impliqués dans le processus de refroidissement de l'atome de rubidium. Dans le cas du rubidium, la transition à 780.24 nm correspond à la transition entre le niveau fondamental 5²S_{1/2} et le niveau supérieur 5²P_{3/2}. Le niveau fondamental 5²S_{1/2} est en fait constitué de deux sous-niveaux dits hyperfins numérotés F=1 et F=2 espacés par une énergie de transition beaucoup plus faible qui se situe dans le domaine des hyperfréquences, qui est de 6.834 GHz pour le rubidium. Le sous-niveau le plus bas est appelé g (pour ground) et le sous-niveau le plus élevé correspondant à cette transition hyperfréquence est appelé e (pour excited). Le niveau 5²P_{3/2} est constitué de quatre niveaux hyperfins numérotés respectivement F'=0, F'=1, F'=2 et F'=3. Pour le rubidium 87, l'écart entre F'=0 et F'=1 est de 72 MHz, l'écart entre F'=1 et F'=2 est de 157 MHz, et, respectivement, l'écart entre F'=2 et F'=3 est de 267 MHz. Au cours d'une expérience d'interaction laser-atomes, on applique généralement un faisceau laser légèrement désaccordé par rapport à ces transitions de manière à obtenir un effet physique particulier tel que l'effet Doppler, l'effet Zeeman, un déplacement lumineux des niveaux d'énergie ou une limitation de l'émission spontanée.

Différents processus de transition mettant en oeuvre au moins deux photons sont actuellement utilisés dans les systèmes d'interféromètres à atomes froids. Certains processus de transition sont basés sur des transitions Raman, de transitions de Bragg ou encore des oscillations de Bloch. A titre d'exemple, on considère ici une configuration basée sur des transitions Raman.

La figure 2 représente schématiquement un système d'interférométrie à atomes refroidis ou ralentis. Une enceinte 8 sous ultra vide contient un nuage d'atomes 7 de départ. Six faisceaux lasers 9 et deux bobines magnétiques 10a, 10b forment un piège magnéto-optique (MOT) pour refroidir les atomes lors de la première étape. Les six faisceaux lasers 9 sont disposés de manière à être orthogonaux et contra-propageant deux par deux. Les deux bobines magnétiques 10a et 10b contribuent à la focalisation très localisée du nuage d'atomes 7. Suite à la première étape de ralentissement des atomes, on procède à une étape de lancement par effet d'accélération ou de chute libre due à la gravité, qui produit un déplacement du nuage d'atomes 11 se propageant dans l'espace libre à l'intérieur de l'enceinte 8 sous vide. La troisième étape comprend l'application d'au moins trois impulsions laser successives 12, 13 et 14 dirigées vers le nuage d'atomes 11. Les trois impulsions laser successives 12, 13 et 14 sont localisées dans le temps et dans l'espace et comportent des raies de longueurs d'onde prédéterminées pour assurer les transitions recherchées. La première impulsion laser 12 est configurée pour commuter partiellement les atomes du niveau fondamental g (ground level), en trait continu, vers le niveau excité e (excited level), en trait pointillé, entre les deux niveaux hyperfins de l'atome alcalin considéré. On procède pour cela par pompage dit Raman à deux photons. La première impulsion 12, dite π/2, lors de la commutation du niveau fondamental *g* vers le niveau excité e, modifie le moment du jet d'atomes et le dévie ainsi d'un certain angle. Chaque atome se retrouve dans une superposition de deux états : un état dévié et un état non dévié, suivant des trajectoires balistiques différentes. Au bout d'une certaine durée, une deuxième impulsion 13 deux fois plus longue, dite π, transfère tous les atomes présents dans l'état e vers l'état g. La nouvelle modification du moment mécanique modifie à nouveau les trajectoires des deux nuages d'atomes, les rapprochant l'un de l'autre. Enfin au bout d'un nouvelle durée, une dernière impulsion laser 14, dite également π/2, recombine les deux nuages d'atomes incidents. On obtient donc deux nuages, un premier nuage d'atomes 15 constitué des atomes dans l'état g ayant suivi les deux trajets, un second nuage d'atomes 16 composé des atomes dans l'état e ayant également suivi les deux trajets. Dans leur état, ces deux nuages d'atomes 15 et 16 sont également des ondes de matière en situation d'interférences complémentaires. Le déphasage accumulé pour former la situation d'interférence est celui des impulsions lasers 12, 13 et 14 aux différents instants d'interception, prenant en compte les effets des trajectoires suivies. L'état d'interférence est donc directement relié aux différences de trajets acquises. La lecture de l'état d'interférence se fait en deux temps, à l'aide d'une nouvelle impulsion laser 17 ajustée en longueur d'onde sur un des états. Un photorécepteur 18 détecte un signal de fluorescence qui résulte de l'absorption de l'impulsion laser 17. Une dernière impulsion laser permet de mesurer un signal de fluorescence global pour déterminer le nombre total d'atomes. Les deux mesures successives donnent l'information sur l'état relatif d'interférence entre atomes, ce qui permet de remonter très précisément à la phase.

Pour enchainer les étapes 1 à 5, il est nécessaire de générer différentes impulsions lasers appliquées à des intervalles de temps de quelques millisecondes et pendant des durées de quelques millisecondes à quelques centaines de millisecondes. Les impulsions des différentes étapes étant à des fréquences optiques différentes, autrement dit des longueurs d'onde différentes, il est nécessaire de pouvoir commuter entre les différentes valeurs de longueurs d'onde de manière rapide, en quelques millisecondes. Dans certaines étapes de transition à deux photons, on applique une impulsion laser ayant deux raies spectrales, de manière à atteindre les valeurs absolues des raies de transition atomiques avec une précision relative de l'ordre de ΔF/F= 10⁻⁹ à 10⁻¹². La puissance lumineuse contenue dans les raies impliquées doit être également maîtrisée avec une bonne précision de l'ordre de 10⁻³. Enfin, la phase entre deux fréquences optiques doit être parfaitement contrôlée et le bruit doit être inférieur au mrad, principalement pour l'interférométrie (étape 3).

On détaille ici un exemple pour chaque étape mise en oeuvre dans un interféromètre à atomes froids.

De manière plus détaillée, la première étape est celle de la capture, du confinement et du ralentissement des atomes. Une première impulsion laser est dirigée dans une enceinte dans laquelle on établit un vide poussé et contenant une vapeur résiduelle d'atomes alcalins, par exemple de rubidium, ceci en présence d'un champ magnétique. Cette première étape constitue le piégeage magnéto-optique (MOT: Magneto-optic Trap). Pendant cette première étape, la longueur d'onde de la transition 5²S_{1/2} => 5²P_{3/2} est dédoublée et ajustée dynamiquement pour permettre la transition, d'une part depuis le niveau F=1 vers le niveau F'=2 et d'autre part depuis F=2 vers F'=3 selon les règles de sélection régissant les transitions autorisées. Dans l'exemple du rubidium, les deux raies sont donc espacées de 6,834-0,267=6,567 GHz. Un faible décalage supplémentaire vers le rouge par exemple de 10 MHz à 20 MHz est introduit par rapport à la résonance de l'absorption. Dans ces conditions, la lumière laser peut être absorbée par un atome de rubidium en mouvement dans une direction quelconque. La longueur d'onde de l'impulsion laser étant légèrement décalée par rapport à la transition atomique, par effet Doppler, ce sont les atomes en mouvement en direction du faisceau lumineux qui présentent la plus grande probabilité d'absorption. Lors de ce processus, l'atome absorbe une certaine quantité de mouvement transférée par le photon. Lors de l'émission spontanée qui fait suite à cette absorption, l'atome devrait en principe restituer intégralement cette quantité de mouvement. L'existence du décalage en longueur d'onde ou en fréquence optique impose néanmoins une transition radiative correspondant exactement à la résonance. L'atome qui a subi cette absorption décalée puis cette radiation centrée est contraint de compenser l'écart des énergies, du fait de la conservation du moment cinétique et de l'énergie. L'atome est donc amené à prélever sur sa propre énergie cinétique pour compenser ce déficit. Cette perte d'énergie modifie et ralentit sa vitesse initiale. Ce ralentissement correspond à un abaissement de la température de l'agitation thermique du gaz d'atomes.

Pendant la durée de l'impulsion laser initiale, réglée sur une longueur d'onde de transition très légèrement décalée, l'ensemble des atomes, éclairés dans la combinaison de faisceaux lasers appliqués en opposition selon les trois axes de l'espace cartésien, soit six faisceaux au total, sont progressivement ralentis. Après quelques dizaines de milliers d'interactions atomes-photons, ce processus permet de passer d'une dispersion de vitesse des atomes piégés de l'ordre de 300m/s correspondant à l'agitation du mouvement brownien à température ambiante à 10cm/s, en quelques centaines de nanosecondes, ce qui correspond à des températures s'approchant du zéro absolu. Pour piéger un grand nombre d'atomes (de l'ordre de 10⁹ atomes), cette première étape peut durer plusieurs centaines de millisecondes. Il est à noter que les deux raies lasers 101, 102 présentes possèdent chacune une puissance lumineuse déterminée et différente l'une de l'autre.

La deuxième étape 2 est plus brève et dure une dizaine de millisecondes et vise à créer ce qui est appelé la mélasse optique. Pendant cette deuxième étape, un décalage supplémentaire en fréquence, par exemple de 100MHz par rapport à la transition F=2 vers F'=3, est introduit au sein des 6 faisceaux. Ce processus permet de passer d'une dispersion de vitesse des atomes piégés de l'ordre de 10 cm/s à 1 cm/s.

La troisième étape est la réalisation de l'interféromètre. Lorsque la première séquence laser dédiée au ralentissement s'interrompt, les atomes peuvent quitter leur position. Sous certaines conditions, ils sont caractérisés par une vitesse initiale dans une direction donnée et connue. Dans le cas d'atomes soumis à la gravité, il s'agit d'une accélération constante, la vitesse des atomes augmente linéairement en fonction du temps. On peut également procéder à un lancement des atomes à une vitesse initiale connue, sous certaines conditions. C'est donc un nuage d'atomes cohérents qui quitte sa position initiale. La source d'atomes étant ainsi contrôlée, il est possible de construire un interféromètre à atomes dont les équivalents des éléments optiques au sens classique du terme (lames séparatrices et miroirs) sont constitués par une succession d'impulsions lasers séparées dans le temps et/ou l'espace.

On considère que l'ensemble du nuage d'atomes 11 qui se propage a été initialement préparé pour que tous les atomes se situent dans l'état d'énergie g. Dans cette situation, les atomes se propagent selon leur vitesse initiale et sont soumis aux effets de l'ensemble des forces inertielles agissant sur eux (gravité, accélération, forces de Coriolis). Ils suivent donc une trajectoire balistique, par exemple parabolique dans le cas du seul effet de la gravité.

Une première impulsion laser 12, dit (π/2) est appliquée pendant une durée T. La première impulsion laser 12 est constituée de deux raies à deux longueurs d'ondes distinctes permettant une transition par pompage dit Raman, à deux photons. Les deux longueurs d'ondes sont écartées exactement de la valeur en fréquence correspondant à la transition hyperfine de 6,834GHz dans le cas du rubidium. Elles sont décalées de 1GHz vers les basses énergies, au niveau intermédiaire virtuel, décalé par rapport à la transition F=2 vers F'=3, par exemple situé 1 GHz en dessous du niveau F'=1. Le modèle d'interaction lumière-matière montre que dans ces conditions, au bout d'une durée T convenablement choisie, selon le phénomène dit des oscillations de Rabi, chaque atome passe dans une superposition d'état fondamental *g* et d'état excité e. Lors de cette transition, les atomes qui passent dans l'état e subissent, dans leur trajectoire, une impulsion mécanique issue de l'absorption de deux photons, transverse ou longitudinale, selon la disposition du faisceau d'interaction qui les sépare, spatialement, des atomes qui demeurent dans l'état g. Il est à noter qu'à cette étape, la phase du laser est transférée sur l'onde des atomes passant de *g* à e. La première impulsion (π/2) joue donc le rôle de lame séparatrice par analogie avec un interféromètre optique.

A la suite de la première interaction (π/2), les deux faisceaux d'atomes se propagent pendant une certaine durée to selon la configuration de l'interféromètre, chacun selon une nouvelle trajectoire et toujours soumis aux effets des forces inertielles déjà mentionnées.

Une deuxième impulsion laser 13, dite (π) de même nature et de mêmes propriétés que l'impulsion π /2 mais de durée 2T deux fois plus longue, est alors appliquée. La deuxième impulsion laser 13 (π) a pour effet de faire passer tous les atomes se trouvant encore dans l'état fondamental *g* vers l'état excité e, leur conférant à leur tour une nouvelle impulsion mécanique, longitudinale ou transverse selon la disposition du faisceau d'interaction, tandis que les atomes qui se trouvaient déjà dans l'état excité e vont repasser vers l'état *g* en subissant une impulsion mécanique dans le sens opposé qui leur confère à nouveau leur impulsion initiale, hormis les effets des forces inertielles en présence. Le laser transfère aux atomes une phase qui dépend de la trajectoire des atomes. La deuxième impulsion laser 13 (π) joue donc le rôle de miroir, par analogie avec l'interféromètre optique.

Une dernière impulsion laser 14, également dite (π/2), interagit avec les deux faisceaux d'atomes qui ont chacun suivi des trajectoires inertielles distinctes. Cette dernière impulsion laser 14 transfère, par pompage à deux photons, la moitié des atomes se trouvant encore dans l'état fondamental (g) vers l'état excité (e), en leur communiquant à nouveau une impulsion mécanique qui les dévie latéralement ou les retarde longitudinalement selon la disposition des faisceaux d'atomes. La dernière impulsion laser 14 transfère également la moitié des atomes se trouvant dans l'état excité (e) vers l'état fondamental (g), avec communication d'une impulsion mécanique de sens opposée à la première. Cette dernière impulsion laser 14 joue ainsi le rôle de lame de séparation de sortie, par analogie à celle d'un interféromètre optique de Mach-Zehnder. En effet, un premier faisceau d'atomes 16 et un second faisceau d'atomes 15 résultants correspondent à des atomes se trouvant dans l'état (g) pour le premier faisceau d'atomes 16 et, respectivement, à l'état (e) pour le second faisceau d'atomes 15. Tous les atomes ont parcouru les deux trajectoires à la fois de l'interféromètre à atomes. On peut montrer que la population normalisée à 1 du premier faisceau d'atomes 16 est une fonction égale au carré du cosinus de l'ensemble des déphasages transférés par le laser lors des différentes interactions. Ces déphasages étant reliés au temps de vols des atomes dans l'interféromètre, on peut donc relier la densité de ce faisceau recombiné à l'ensemble des accélérations subies à l'intérieur de l'interféromètre. On peut également montrer que la population normalisée à 1 des atomes du second faisceau d'atomes 15 est égale au carré du sinus des mêmes déphasages.

Le comptage du nombre d'atomes dans l'un des faisceaux d'atomes 15 ou 16, puis le comptage du nombre total d'atomes dans les deux faisceaux d'atomes de sortie 15, 16 permet de recouvrer l'état d'interférence normalisé en sortie et de calculer le déphasage total subi par les atomes et provoqué par l'ensemble des accélérations qu'ils ont subi pendant entre la première impulsion laser et la dernière impulsion laser.

L'opération de comptage s'effectue à l'aide d'un premier faisceau laser 17 correspondant strictement, dans le cas du rubidium, à la transition F=2 vers F'=3 soit la longueur d'onde de 780,24nm (étape 4). L'absorption entraine une fluorescence par émission spontanée lorsque les atomes se désexcitent. La puissance lumineuse qui résulte de cette fluorescence est proportionnelle au carré du cosinus du déphasage recherché et peut être mesurée par un photodétecteur linéaire. Immédiatement après cette première mesure, une deuxième raie laser espacée en fréquence de 6,6 GHz de la première, correspondant à la transition hyperfine du niveau fondamental déjà mentionnée, permet de mesurer par fluorescence l'ensemble des atomes situés à la fois dans le niveau excité (e) et dans le niveau fondamental (g) (étape 5). Le rapport entre les deux mesures de fluorescence fournit donc la valeur normalisée de la fonction cosinus recherchée.

On comprend donc que la source laser qui est généralement unique pour l'ensemble de l'expérience doit permettre d'appliquer, à différents instants et à différentes localisations dans la chambre à vide 8, des faisceaux lasers dont la longueur d'onde commute rapidement et très précisément. Cette source laser doit aussi pouvoir générer une à deux raies extrêmement proches l'une de l'autre, tout en étant référencée de manière absolue sur les transitions de l'atome alcalin (par exemple de césium, rubidium ou potassium) considéré.

La publication V. Ménoret et al. « Dual-wavelength laser source for onboard atom interferometry », Optics Letters, vol. 36, no. 21, pp. 4128-4130, 2011 décrit une source laser non accordable. Plus récemment, la publication B. Battelier et al. « Development of compact cold-atom sensors for inertial navigation», Proceedings of SPIE, Quantum Optics, vol. 9900 p. 990004, 2016 met en oeuvre un système de source laser commutable en fréquence optique. Ce système utilise une chaîne d'un à plusieurs modulateurs optiques de phase et de filtres optiques disposés en cascade et commandés par une ou plusieurs sources de signaux hyperfréquences synchronisés. L'architecture d'un tel système de source laser à base de composants à fibre optique, selon l'état de l'art, repose ainsi sur une mise en oeuvre complexe de modulateurs optiques de phase. Ces systèmes de source laser commutables et ajustables présentent l'inconvénient de générer non seulement les raies utiles mais également d'autres raies parasites susceptibles de nuire à l'efficacité de lecture du phénomène d'interférences atomiques en sortie.

Un des buts de l'invention est de proposer un système pour interaction entre faisceau laser et des espèces chimiques, adapté pour générer une seule ou deux raies laser ayant un décalage prédéterminé en fréquence optique d'au plus quelques dizaines de gigahertz par rapport à une fréquence optique de référence de l'espèce chimique considérée, et pour commuter rapidement ce décalage en fréquence optique. De préférence les espèces chimiques sont des atomes, ions ou molécules dans un espace sous vide.

Un des buts de l'invention est de proposer une architecture alternative de système d'interféromètre à atomes froids et à impulsions laser, plus simple et moins coûteuse.

### OBJET DE L'INVENTION

Afin de remédier à l'inconvénient précité de l'état de la technique, la présente invention propose un dispositif d'interaction entre un faisceau laser et une transition énergétique hyperfine d'une espèce chimique disposée dans un espace sous vide, comprenant une source laser adaptée pour émettre un faisceau laser source à une fréquence optique initiale.

Plus particulièrement, on propose selon l'invention un dispositif comportant en outre un modulateur électro-optique à bande latérale unique comprenant un guide d'onde optique d'entrée adapté pour recevoir le faisceau laser source et un guide d'onde optique de sortie adapté pour générer un faisceau laser de sortie, le modulateur électro-optique ayant une première électrode haute fréquence, une autre électrode haute fréquence et une pluralité d'électrodes basse fréquence, un générateur de tension basse fréquence, configuré pour appliquer sur chacune desdites électrodes basse fréquence une tension basse fréquence adaptée pour générer un déphasage optique prédéterminé dans le guide d'onde optique, et un système électronique comprenant une horloge, le système électronique étant adapté pour générer un premier signal électrique modulé à une première pulsation et, respectivement, un autre signal électrique modulé à la première pulsation synchronisés par l'horloge, le système électronique étant adapté pour ajuster en amplitude et en phase le premier signal électrique modulé relativement à l'autre signal électrique modulé à la première pulsation, le système électronique étant adapté pour appliquer simultanément le premier signal électrique modulé à la première pulsation sur la première électrode haute fréquence et, respectivement, l'autre signal électrique modulé à la première pulsation sur l'autre électrode haute fréquence, et le système électronique étant adapté pour commuter et accorder la première pulsation dans une gamme spectrale hyperfréquence s'étendant au plus sur 100 gigahertz de manière à commuter en fréquence le faisceau laser de sortie vers une première fréquence optique décalée de la première pulsation par rapport à la fréquence optique initiale tout en atténuant le faisceau laser de sortie à la fréquence optique initiale et aux autres harmoniques de la première pulsation par rapport à la fréquence optique initiale.

De façon avantageuse, le système électronique est adapté pour générer un deuxième signal électrique modulé à une deuxième pulsation et, respectivement, un autre signal électrique modulé à la deuxième pulsation, le deuxième signal électrique modulé et l'autre signal électrique modulé à la deuxième pulsation étant synchronisés par l'horloge, le système électronique étant adapté pour ajuster en amplitude et en phase le deuxième signal électrique modulé à la deuxième pulsation par rapport au premier signal électrique modulé à la première pulsation et former un premier signal électrique doublement modulé à la première pulsation et à la deuxième pulsation, le système électronique étant adapté pour ajuster en amplitude et en phase l'autre signal électrique modulé à la deuxième pulsation par rapport à l'autre signal électrique modulé à la première pulsation et former un autre signal électrique doublement modulé à la première pulsation et à la deuxième pulsation, et le système électronique étant adapté pour ajuster en déphasage électrique le premier signal électrique doublement modulé par rapport à l'autre signal électrique doublement modulé, et le système électronique étant adapté pour appliquer simultanément le premier signal électrique doublement modulé sur la première électrode haute fréquence et, respectivement, l'autre signal électrique doublement modulé sur l'autre électrode haute fréquence, et le système électronique étant adapté pour commuter et accorder la deuxième pulsation dans une gamme spectrale hyperfréquence s'étendant au plus sur 100 gigahertz de manière à commuter en fréquence le faisceau laser de sortie simultanément vers la première fréquence optique décalée de la première pulsation par rapport à la fréquence optique initiale et vers une deuxième fréquence optique décalée de la deuxième pulsation par rapport à la fréquence optique initiale, la première fréquence optique décalée et la deuxième fréquence optique décalée étant décalées dans le même sens par rapport à la fréquence optique initiale, tout atténuant le faisceau laser de sortie aux autres harmoniques de la deuxième pulsation par rapport à la fréquence optique initiale.

D'autres caractéristiques non limitatives et avantageuses du dispositif conforme à l'invention, prises individuellement ou selon toutes les combinaisons techniquement possibles, sont les suivantes :
- le système électronique comporte un synthétiseur électronique radiofréquence adapté pour générer un signal électrique modulé à la première pulsation et un coupleur hybride ayant un premier canal de sortie et un deuxième canal de sortie, le premier canal de sortie étant relié électriquement à la première électrode haute fréquence, et, respectivement, le deuxième canal de sortie étant relié électriquement à l'autre électrode haute fréquence, le coupleur hybride étant adapté pour recevoir le signal électrique modulé à la première pulsation et pour générer le premier signal électrique modulé à la première pulsation sur le premier canal de sortie et, respectivement, l'autre signal électrique modulé à la première pulsation en quadrature de phase sur le deuxième canal de sortie ;
- le synthétiseur électronique radiofréquence est adapté pour générer un signal électrique modulé à la deuxième pulsation, le coupleur hybride étant adapté pour recevoir le signal électrique modulé à la deuxième pulsation et pour générer le deuxième signal électrique modulé à la deuxième pulsation sur le premier canal de sortie et, respectivement, l'autre signal électrique modulé à la deuxième pulsation en quadrature de phase sur le deuxième canal de sortie ;
- le dispositif comprend en outre un composant optique non-linéaire disposé pour recevoir le faisceau laser de sortie à la première fréquence optique décalée de la première pulsation par rapport à la fréquence optique initiale et/ou à la deuxième fréquence optique décalée de la deuxième pulsation par rapport à la fréquence optique initiale, le composant optique non-linéaire étant adapté pour générer un faisceau laser à une fréquence optique double de la première fréquence optique décalée, à une fréquence optique double de la deuxième fréquence optique décalée, et/ou respectivement, à une fréquence optique somme de la première fréquence optique décalée et de la deuxième fréquence optique décalée ;
- le dispositif comprend en outre un commutateur optique, le commutateur optique ayant une voie d'entrée et une pluralité de voies de sortie, le commutateur optique étant adapté pour recevoir sur la voie d'entrée et diriger sur l'une des voies de sortie le faisceau laser de sortie à la première fréquence optique décalée de la première pulsation par rapport à la fréquence optique initiale, le faisceau laser de sortie à la deuxième fréquence optique décalée de la deuxième pulsation par rapport à la fréquence optique initiale, le faisceau laser à la fréquence optique double de la première fréquence optique décalée, le faisceau laser à la fréquence optique double de la deuxième fréquence optique décalée, et/ou respectivement, le faisceau laser à la fréquence optique somme de la première fréquence optique décalée et de la deuxième fréquence optique décalée ;
- le dispositif comprend une boucle électronique de contre-réaction comprenant un photodétecteur, une source électrique et un mélangeur de signaux, le photodétecteur étant adapté pour mesurer un signal d'absorption par l'espèce chimique du faisceau laser de sortie à la première fréquence optique décalée, à la deuxième fréquence optique décalée, du faisceau laser à la fréquence optique double de la première fréquence optique décalée, du faisceau laser à la fréquence optique double de la deuxième fréquence optique décalée, et/ou respectivement, du faisceau laser à la fréquence optique somme de la première fréquence optique décalée et de la deuxième fréquence optique décalée, la source électrique étant adaptée pour générer un signal basse fréquence et le mélangeur de signaux étant adapté pour mélanger le signal d'absorption et le signal basse fréquence pour former un signal d'erreur ;
- la boucle électronique de contre-réaction est configurée pour appliquer par intermittence le signal d'erreur à la source laser de manière à ajuster la fréquence optique initiale sur une transition énergétique hyperfine de référence de l'espèce chimique ;
- la boucle électronique de contre-réaction est configurée pour appliquer par intermittence le signal d'erreur au système électronique de manière à ajuster la première pulsation et/ou la deuxième pulsation ;
- la source laser comprend un laser à semi-conducteur ou un laser à fibre optique.

L'invention propose également un interféromètre à atomes froids et à impulsions laser comprenant un dispositif selon l'un des modes de réalisation décrits dans lequel l'espèce chimique est constituée d'atomes et dans lequel le synthétiseur électronique radiofréquence est adapté pour commuter la première pulsation et la deuxième pulsation suivant une séquence prédéterminée.

L'invention propose aussi un appareil de spectrométrie optique hyperfine comprenant un dispositif selon l'un des modes de réalisation décrits dans lequel l'espèce chimique est constituée d'atomes, d'ions ou de molécules et comprenant un détecteur adapté pour mesurer une transition énergétique hyperfine de l'espèce chimique par absorption, réflexion ou diffusion du faisceau laser décalé en fréquence.

L'invention propose également un procédé d'interaction entre un faisceau laser et une transition énergétique hyperfine d'une espèce chimique comprenant les étapes suivantes :
- confinement de l'espèce chimique dans un espace sous vide,
- émission d'un faisceau laser source à une fréquence optique initiale;
- injection du faisceau laser source sur un guide d'onde optique d'entrée d'un modulateur électro-optique à bande latérale unique,
- génération d'un premier signal électrique modulé à une première pulsation synchronisé sur une horloge et, respectivement, d'un autre signal électrique modulé à la première pulsation synchronisé sur l'horloge, la première pulsation étant commutable et ajustable dans une gamme spectrale hyperfréquence s'étendant au plus sur 100 gigahertz,
- ajustement en amplitude et en phase du premier signal électrique modulé relativement à l'autre signal électrique modulé à la première pulsation,
- application simultanée du premier signal électrique modulé à la première pulsation sur une première électrode haute fréquence du modulateur électro-optique et, respectivement, de l'autre signal électrique modulé à la première pulsation sur une autre électrode haute fréquence du modulateur électro-optique de manière à générer sélectivement, sur un guide d'onde optique de sortie du modulateur électro-optique, un faisceau laser de sortie à une première fréquence optique décalée de la première pulsation par rapport à la fréquence optique initiale tout en atténuant le faisceau laser à la fréquence optique initiale et aux autres fréquences harmoniques de la première pulsation par rapport à la fréquence optique initiale et,
- amplification optique du faisceau laser de sortie pour générer un faisceau laser amplifié à la première fréquence optique décalée, et
- transmission du premier faisceau laser amplifié à la première fréquence optique décalée en direction de l'espèce chimique de manière à interagir avec une transition énergétique hyperfine de l'espèce chimique.

De préférence, le procédé comprend en outre les étapes suivantes :
- génération d'un deuxième signal électrique modulé à une deuxième pulsation synchronisé sur l'horloge et, respectivement, d'un autre signal électrique modulé à la deuxième pulsation synchronisé sur l'horloge, la deuxième pulsation étant commutable et ajustable dans une gamme spectrale hyperfréquence s'étendant au plus sur 100 gigahertz,
- ajustement en amplitude et en phase du deuxième signal électrique modulé à la deuxième pulsation par rapport au premier signal électrique modulé à la première pulsation pour former un premier signal électrique doublement modulé à la première pulsation et à la deuxième pulsation, et ajustement en amplitude et en phase de l'autre signal électrique modulé à la deuxième pulsation par rapport à l'autre signal électrique modulé à la première pulsation pour former un autre signal électrique doublement modulé à la première pulsation et à la deuxième pulsation,
- ajustement de phase électrique du premier signal électrique doublement modulé par rapport à l'autre signal électrique doublement modulé,
- application simultanée du premier signal électrique doublement modulé sur la première électrode haute fréquence du modulateur électro-optique et, respectivement, de l'autre signal électrique doublement modulé sur l'autre électrode haute fréquence du modulateur électro-optique de manière à générer sur le guide d'onde optique de sortie du modulateur électro-optique, un faisceau laser de sortie commuté simultanément vers la première fréquence optique décalée de la première pulsation par rapport à la fréquence optique initiale et vers une deuxième fréquence optique décalée de la deuxième pulsation par rapport à la fréquence optique initiale, la première fréquence optique décalée et la deuxième fréquence optique décalée étant décalées dans le même sens par rapport à la fréquence optique initiale,
- amplification optique du faisceau laser de sortie pour générer un faisceau laser amplifié simultanément à la première fréquence optique décalée et à la deuxième fréquence optique décalée, et
- transmission du faisceau laser amplifié simultanément à la première fréquence optique décalée et à la deuxième fréquence optique décalée en direction de l'espèce chimique.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 représente schématiquement les niveaux d'énergie et sous-niveaux hyperfins de l'atome de rubidium 87 (transition D2) ;
- la figure 2 représente schématiquement une enceinte à vide configurée pour une expérience d'interférométrie avec des atomes froids ;
- la figure 3 représente schématiquement un système de source laser commutable pour système interférométrique à atomes froids selon l'art antérieur, ce système de source laser étant basé sur l'utilisation de deux lasers à semi-conducteurs en mode maître-esclave ;
- la figure 4 représente schématiquement un autre système de source laser commutable pour système interférométrique à atomes froids selon l'art antérieur, ce système de source laser étant basé sur l'utilisation d'une seule source laser, de plusieurs modulateurs de phase disposés en cascade et d'un filtre optique accordable ;
- la figure 5 représente schématiquement en vue de dessus un modulateur électro-optique à bande latérale unique destiné à être utilisé dans un système de manipulation d'atomes froids par interaction avec un faisceau laser, pour décaler en fréquence le faisceau laser source vers une fréquence optique décalée par rapport à la fréquence optique initiale ;
- la figure 6 représente schématiquement le modulateur électro-optique utilisé dans un système de manipulation d'atomes froids par interaction avec un faisceau laser selon la présente divulgation dans lequel le modulateur EO à bande latérale unique est utilisé pour commuter et dédoubler le faisceau laser simultanément vers une première fréquence optique décalée d'une première pulsation hyperfréquence Ω₁ et, respectivement, une deuxième fréquence optique décalée d'une deuxième pulsation hyperfréquence Ω₂ par rapport à la fréquence optique initiale ;
- la figure 7 représente schématiquement un sous module de système interférométrique à atomes froids combinant un modulateur électro-optique à bande latérale unique et un composant optique non-linéaire doubleur de fréquence ;
- la figure 8 représente schématiquement un système de source laser agile selon un exemple de réalisation ;
- la figure 9 représente schématiquement un système de source laser agile selon un autre exemple de réalisation ;
- la figure 10 représente schématiquement un système de source laser agile selon encore un autre exemple de réalisation ;
- la figure 11 représente schématiquement un procédé d'interaction laser-atomes comprenant respectivement les étapes de : refroidissement d'atomes (étape 1), de formation d'une mélasse optique (étape 2), et dans les applications d'interférométrie atomique (étape 3), de détection par fluorescence laser (étape 4), de comptage du nombre total d'atomes (étape 5) et de sondage d'une raie de transition atomique (étape 6), ainsi que les fréquences optiques impliquées dans chacune de ces différentes étapes dans l'exemple de l'atome de rubidium.

### Dispositif

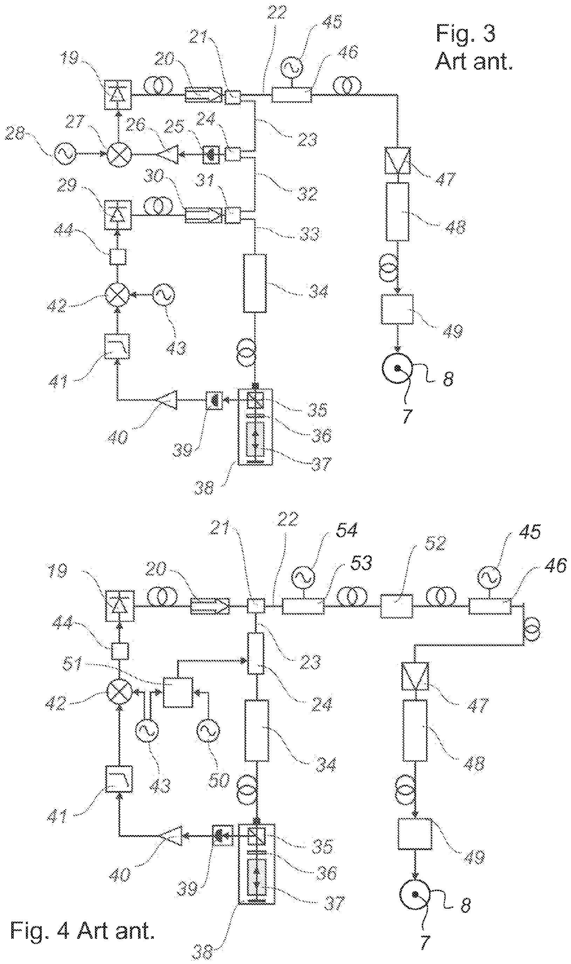

Sur la figure 3, on a représenté un système de source laser accordable ou commutable en fréquence optique pour un système interférométrique à atomes froids selon l'art antérieur. Ce système de source laser est basé sur une architecture à deux sources laser à semi-conducteur 19 et 29 fonctionnant en mode maitre-esclave.

Le système de source laser comprend une première source laser 19 ou laser principal. La première source laser 19 est par exemple une source à base de semi-conducteur intégrée dans une structure de type réflecteur de Bragg distribué (DBR pour Distributed Bragg Reflector). La première source laser 19 émet un faisceau laser source de manière continue qui présente une très grande finesse de raie (quelques kHz). Une modification de la température du réflecteur de Bragg associé au laser permet d'accorder la longueur d'onde du faisceau laser source. Un isolateur optique 20 reçoit le faisceau laser source et permet de limiter la réflexion de lumière parasite en direction du laser source afin d'éviter toute instabilité.

Un coupleur optique 21 ayant une branche d'entrée et deux branches de sortie 22 et 23 reçoit le faisceau laser source transmis par l'isolateur optique 20. Le coupleur optique 21 est de préférence un coupleur à fibre optique. Le coupleur optique 21 sépare le faisceau laser source en une portion transmise sur la branche de sortie 22 et une autre portion transmise sur l'autre branche de sortie 23, qui est utilisée pour le verrouillage permanent de la première source laser 19 sur une deuxième source laser 29 de référence. Pour cela, la deuxième source laser 29 est reliée à un autre isolateur optique 30 puis à un autre coupleur optique 31 ayant une branche d'entrée et deux branches de sortie 32 et 33. Considérons la branche 33 destinée à l'asservissement sur une raie atomique déterminée de référence. La deuxième source laser 29 émet un faisceau de lumière qui est transmis sur la branche 33 en direction d'un composant optique non-linéaire 34, par exemple de type PPLN (Periodically Poled Lithium Niobate) qui, par effet optique non linéaire, effectue une génération de seconde harmonique et donc un doublage de fréquence optique. Autrement dit, la longueur d'onde du faisceau de seconde harmonique est égale à la moitié de la longueur d'onde du faisceau source. La deuxième source laser 29 à semi-conducteur émet une raie source autour de 1560 nm. Le composant optique non-linéaire 34 convertit la raie source à 1560 nm en une raie de seconde harmonique située autour de 780 nm, qui est proche de la raie de transition du rubidium. Le faisceau à 780 nm traverse un cube optique séparateur de faisceau 35 puis une lame quart d'onde 36 afin d'obtenir un état de polarisation circulaire. Le faisceau de seconde harmonique polarisé circulairement éclaire une cellule basse pression 37 contenant un gaz de rubidium, dans le présent exemple. Un miroir 38 renvoie le faisceau de seconde harmonique vers le séparateur de faisceau 35. Le faisceau réfléchi éclaire une photodiode 39 qui génère un signal d'absorption qui est amplifié par un amplificateur de signal électronique 40. Une source électrique 43 génère un signal basse fréquence. Un mélangeur de signaux 42 mélange le signal basse fréquence avec le signal d'absorption amplifié et le signal mélangé est ensuite filtré par un filtre électronique passe-bas 41. Le filtre électronique passe-bas 41 génère un signal d'erreur qui est intégré par un composant électronique de contre-réaction 44 avant d'être appliquée à la deuxième source laser 29 pour corriger la longueur d'onde du faisceau émis. Ainsi, le faisceau laser émis par la deuxième source laser 29 est parfaitement ajusté sur une transition ou raie d'absorption du rubidium, pendant son double passage à travers la cellule basse pression 37. Ainsi, la deuxième source laser 29 est verrouillée en continu et de manière absolue par rapport à la valeur de la transition recherchée pour l'atome considéré.

La deuxième source laser 29 de référence est utilisée pour l'asservissement sur une raie d'absorption spectrale de l'atome alcalin (Rubidium par exemple) mis en oeuvre dans l'expérience. Selon l'art antérieur, cette étape d'asservissement en continu est essentielle pour la suite des opérations.

Un autre coupleur optique 24 ayant deux branches d'entrée formées par les branches 23, 32 et une branche de sortie est disposé de manière à asservir le laser principal 19 sur la deuxième source laser 29. La branche d'entrée 23 reçoit un faisceau laser en provenance du laser principal 19. L'autre branche d'entrée 32 reçoit un autre faisceau laser émis par le laser de référence 29. Le coupleur optique 24 mélange ces deux faisceaux. Sur la branche de sortie du deuxième coupleur optique 24, un photodétecteur 25 détecte un signal de battement qui est amplifié par un amplificateur 26 de signal électronique. Un circuit comparateur phase fréquence 27 pour contre-réaction reçoit d'une part une fréquence égale en général à une fraction (par exemple d'un facteur 2 ou 8) de la fréquence optique issue du battement entre les deux ondes de fréquences optiques décalées et d'autre part une porteuse issue d'une source électrique radiofréquence (RF) 28. Le circuit 27 génère un signal d'erreur qui est appliqué au laser principal 19 pour ajuster la longueur d'onde recherchée, décalée par rapport à la deuxième source laser 29 d'une valeur prédéterminée par la source électrique 28. D'autres schémas de verrouillage en longueur d'onde sont également possibles avec des variantes.

Le laser principal 19 est ainsi asservi sur une longueur d'onde légèrement décalée par rapport à la raie de référence du rubidium, par ce système de verrouillage maître-esclave. L'autre branche de sortie 22 du coupleur optique 21 est destinée à une chambre d'expérience pour interférométrie atomique sur des atomes de rubidium. Sur la branche de sortie 22 sont disposés en série un modulateur optique de phase 46, un amplificateur optique 47, un deuxième composant optique non linéaire 48 et un dernier modulateur d'amplitude 49. Le modulateur optique de phase 46 est piloté par un synthétiseur 45 fournissant une porteuse hyperfréquence. En sortie du modulateur optique de phase 46, on obtient un faisceau modulé comprenant des raies latérales générées autour de la fréquence optique du laser principal 19. L'amplificateur optique 47 permet ensuite d'ajuster le niveau de puissance optique pour disposer du nombre de photons nécessaires en sortie de système. Le deuxième composant optique non linéaire 48 de type PPLN doubleur de fréquence permet une génération de seconde harmonique à partir des raies contenues dans le faisceau modulé. Le dernier modulateur d'amplitude 49, par exemple de type acousto-optique, permet de contrôler la commutation des faisceaux destinés à éclairer une chambre d'expérience contenant le nuage d'atomes froids, comme illustrée par exemple sur la figure 2.

La figure 3 représente une première architecture de système de source laser accordable pour interféromètre atomique basée sur l'utilisation d'un système de deux laser en mode maître-esclave, l'un des lasers 29 étant verrouillé en continu sur l'absorption d'une raie atomique de référence et l'autre laser 19 étant décalé en fréquence à l'aide d'un circuit mélangeur et comparateur par rapport à cette fréquence optique de référence, un modulateur de phase 46 permettant la génération des raies latérales à partir de cette source décalée.

Ainsi, le système de source de la figure 3 permet de générer une à deux raies latérales à partir d'une raie laser unique pour effectuer une séquence d'étapes telle que représentée sur la figure 2. Le système de source à deux lasers maitre esclave est reconfigurable en permanence, ce qui permet une commutation des raies laser particulièrement agile, c'est-à-dire à la fois rapide et très précise en fréquence optique.

Toutefois, le système de source à deux lasers maitre esclave nécessite au moins deux lasers semi-conducteurs 19, 29. De plus, la gestion du contrôle des longueurs d'onde entre les deux lasers semi-conducteurs implique une mise en oeuvre complexe. En effet, le modulateur optique de phase 46 est nécessaire pour introduire les raies latérales et atteindre ainsi le résultat recherché. Or, le modulateur optique de phase 46 génère non seulement les raies latérales recherchées, mais également des raies latérales indésirables sur les harmoniques supérieures à des niveaux de puissance qui ne sont généralement pas négligeables. Ces harmoniques indésirables constituent des sources d'interféromètres parasites et sont des sources d'erreurs dans le signal de sortie, autrement dit le signal d'interférence mesuré. A titre d'exemple, considérons le cas d'un modulateur de phase piloté par une source hyperfréquence à 6,8 GHz (cas du rubidium) d'amplitude en tension électrique V₀. L'indice de modulation est égal à πV₀/V_{π} où V_{π} est la tension demi-onde du modulateur, c'est-à-dire la tension électrique adaptée pour introduire un déphasage de π radians sur l'onde optique qui le traverse. Il en résulte qu'une partie de l'énergie est convertie dans une raie située à +6.8GHz de la fréquence optique initiale ωo, ce qui est l'effet recherché. Le rapport de puissance entre la fréquence optique initiale à ωo et la bande latérale décalée de la première pulsation hyperfréquence est égal à 1 lorsque l'indice de modulation est égal à 1,43. Il convient cependant de noter que d'autres raies sont également créées à cette occasion aux fréquences harmoniques de la raie centrale, c'est-à-dire à -6.8GHz, mais aussi à ±13,4GHz, ±20,4GHz etc.

Dans ces conditions, on peut noter l'apparition d'une raie parasite importante à -6.8 GHz d'amplitude égale à la bande latérale utile à +6.8 GHz. L'amplitude en puissance des autres raies additionnelles, notamment à ±13,4GHz, est égale à 40% de celle des raies à ±6.8GHz, ce qui n'est pas négligeable. Ces raies parasites d'amplitude non négligeable sont susceptibles de limiter significativement les performances de l'interféromètre à atomes froids.

La figure 4 illustre un autre exemple de système de source laser permettant de piloter une expérience d'interféromètre à atomes froids selon l'art antérieur récent (B. Battelier et al., « Development of compact cold-atom sensors for inertial navigation », Quantum Optics, Proc. SPIE, Vol. 9900, 990004, 2016). Le système de la figure 4 repose sur l'utilisation d'un unique laser semi-conducteur 19 et d'une cascade de modulateurs optiques de phase pour décaler une raie laser par rapport à une référence atomique, puis générer différentes raies latérales multiples recherchées.

L'architecture du système de la figure 4 comporte une source laser 19, par exemple un laser semi-conducteur, qui émet un faisceau laser source à une fréquence optique initiale. Un isolateur optique 20 reçoit le faisceau laser source via une fibre optique. Un coupleur optique 21 ayant une branche d'entrée et deux branches de sortie 22 et 23 reçoit le faisceau laser source transmis par l'isolateur optique 20. La branche 23 du coupleur 21 est utilisée pour l'asservissement en continu de la source laser 19 sur une raie atomique de l'atome considéré. La branche de sortie 23 est reliée à un premier modulateur optique de phase 124, piloté par une source micro-onde 50 et/ou par une source basse fréquence 43 combinées dans un mélangeur de signaux 51. La lumière modulée traverse ensuite un composant optique non-linéaire 34, qui par effet optique non linéaire réalise une génération de seconde harmonique. La sortie du modulateur de phase 124 est reliée à un premier composant optique non linéaire 34 de type PPLN (Periodically Poled Lithium Niobate) doubleur de fréquence. Les raies modulées à 1560 nm sont ainsi converties en raies autour de 780 nm, ce qui correspond à la raie de transition du rubidium, dans l'exemple considéré. Le faisceau à 780 nm traverse un cube optique séparateur de faisceaux 35 puis une lame biréfringente 36 de type lame quart d'onde afin d'obtenir un état de polarisation circulaire. Le faisceau à 780 nm polarisé circulairement éclaire une cellule basse pression 37 d'absorption contenant un gaz de rubidium. Un miroir réfléchissant 38 renvoie le faisceau à 780 nm vers le séparateur de faisceau 35. Le faisceau réfléchi éclaire une photodiode 39 qui génère un signal d'absorption qui est amplifié par un amplificateur de signal électronique 40. Une source électrique 43 génère un signal basse fréquence. Un mélangeur de signaux 42 mélange le signal basse fréquence avec le signal d'absorption amplifié et un filtre électronique passe-bas 41 filtre le signal obtenu, ce qui génère un signal d'erreur. Un composant électronique de contre-réaction 44, aussi appelé intégrateur, applique le signal d'erreur sur le laser à semi-conducteur 19 pour ajuster précisément la longueur d'onde émise par la source laser 19 sur la transition atomique recherchée du rubidium. Ainsi, la source laser 19 à semi-conducteur est verrouillée et référencé de manière absolue sur cette valeur. Autrement dit, la source laser 19 est asservie en longueur d'onde sur une transition atomique de référence.

L'autre branche de sortie 22 du coupleur 21 est reliée à un deuxième modulateur de phase 53 commandé par un synthétiseur 54 générant un signal électrique modulé à une première pulsation hyperfréquence pour produire un premier décalage spectral de la raie laser. Le modulateur de phase 53 ainsi piloté module en phase la lumière de la source laser 19 et crée des bandes latérales. La lumière modulée en phase présente plusieurs raies latérales. Un filtre optique 52 accordable à bande spectrale étroite, par exemple un filtre de Fabry-Perot, permet de sélectionner une raie principale parmi ces raies latérales, ce qui équivaut à translater ou décaler en fréquence optique la raie de la source laser 19 par rapport à la transition atomique de référence.

Un troisième modulateur optique de phase 46 est placé en cascade après le filtre accordable 52. Ce modulateur optique de phase 46 est piloté par une autre source hyperfréquence 45 qui permet de générer une deuxième fréquence optique décalée par rapport à la raie principale, de manière analogue au modulateur optique 46 décrit en lien avec la figure 3. Ce troisième modulateur optique de phase 46 est suivi d'un amplificateur optique 47, d'un deuxième composant optique non linéaire 48 de type PPLN doubleur de fréquence et d'un modulateur optique d'amplitude 49.

Le système de source accordable et commutable de la figure 4 permet de décaler la fréquence optique d'une raie laser à partir d'une référence atomique, puis de générer des raies latérales multiples à des fréquences optiques prédéterminées, ce qui équivaut à translater ou décaler la fréquence optique de la source laser initiale.

Le système de source laser de la figure 4 permet de créer une ou deux raies latérales à partir d'une raie laser unique. Cette configuration permet une grande agilité de commutation des raies spectrales. Ce système de source laser de la figure 4 y parvient, dans cette description à l'aide d'une cascade de deux modulateurs optiques de phase 53 et 46, entre lesquels est interposé un filtre optique 52 permettant de sélectionner une première raie, variable en position par rapport à la référence. Le deuxième modulateur de phase 46 est nécessaire pour introduire d'autres raies latérales et pour atteindre le résultat recherché. Cependant, cette configuration est d'une part complexe de mise en oeuvre et nécessite, d'autre part, un filtre optique accordable supplémentaire, de type Fabry-Pérot. Cette configuration est d'un coût élevé. De plus, ce système de source laser pour interféromètre atomique génère un grand nombre de raies parasites entrainant une erreur sur la mesure et une perte d'efficacité du système de source laser.

En résumé, le système de source laser pour interféromètre à atomes froids de la figure 3 repose sur l'utilisation de deux lasers semi-conducteurs verrouillés entre eux en mode maître-esclave. Le système de source laser pour interféromètre à atomes froids de la figure 4 nécessite une pluralité de modulateurs de phase destinés à générer des raies latérales, qui sont ensuite filtrées puis dédoublées à nouveau pour parvenir à obtenir un peigne de raies décalées en fréquence avec une capacité de commutation rapide. Néanmoins, ces systèmes génèrent beaucoup plus de raies que nécessaire. Ces raies indésirables peuvent engendrer des interactions parasites, par exemple des interféromètres parasites qui sont sources d'erreurs dans l'interprétation du phénomène d'interférences atomiques que l'on cherche à mesurer.

La présente divulgation propose une architecture de système de source laser pour interagir avec des espèces chimiques basée sur une combinaison d'une seule source laser 19 et d'un seul modulateur électro-optique 55, dit modulateur à bande latérale unique (BLU). Ce système de source laser agile trouve des applications en particulier dans un système de manipulation d'espèces chimiques par interaction laser, tel que par exemple un interféromètre à atomes froids.

Un modulateur électro-optique à bande latérale unique (BLU) est connu et appliqué dans le domaine des télécommunications optiques dans lequel les faisceaux optiques ont une longueur d'onde de 1550 nm et sont situés dans des gammes de puissance et d'énergie limitées et très inférieures aux puissances et énergies nécessaires pour les applications d'interaction entre faisceau laser et espèces chimiques, par exemple en interférométrie atomique. Un modulateur électro-optique à bande latérale unique (BLU) est utilisé dans l'art antérieur pour commuter une fréquence optique initiale vers une et une seule autre fréquence optique en fonction d'un signal électrique modulé appliqué, d'où la dénomination de modulateur électro-optique à bande latérale unique (BLU).

Toutefois, les étapes 1, 2 et 5 d'interaction entre atomes froids et laser requièrent l'application simultanée, non pas d'une seule fréquence optique décalée par rapport à une transition atomique, mais l'application simultanée de deux fréquences optiques décalées de manière prédéterminée et très précise par rapport à une fréquence optique de référence, chaque fréquence optique décalée ayant de plus une amplitude contrôlée. En interférométrie atomique, l'étape 3 requiert aussi l'application simultanée de deux fréquences optiques décalées.

Dans le dispositif d'interaction entre faisceau laser et espèces chimiques, par exemple d'interaction laser-atomes froids, selon la présente divulgation, un seul modulateur électro-optique à bande latérale unique remplace avantageusement plusieurs modulateurs optiques de phase, filtre(s) optique(s) et/ou diode(s) laser supplémentaire(s) des systèmes de source laser accordable pour interféromètre à atomes froids de l'art antérieur.

L'utilisation d'un modulateur électro-optique à bande latérale unique selon la présente divulgation permet de produire sélectivement une ou deux raies lumineuses utiles aux processus impliqués tout en garantissant une forte réjection de toutes les raies parasites indésirables.

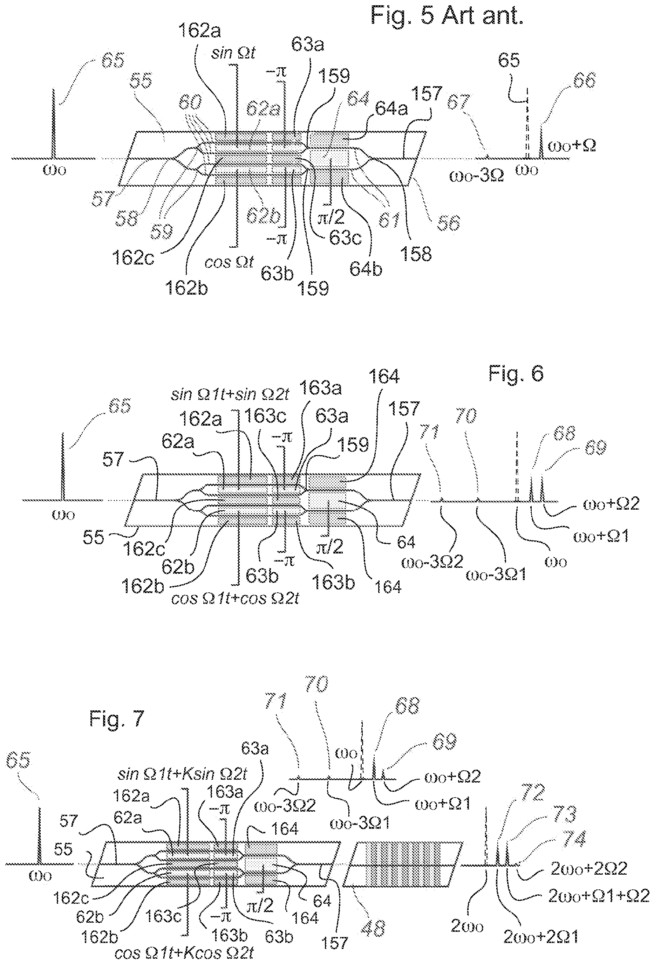

La figure 5 représente un modulateur électro-optique 55 de type modulateur QPSK (quadrature phase shift keying) ou bien encore I&Q ou bien enfin SSB (Single Side Band). En français, on parle également de modulateur BLU (Bande Latérale Unique). Le modulateur électro-optique BLU 55 est réalisé par intégration dans un substrat monocristallin 56 possédant des coefficients électro-optiques non nuls, par exemple de niobate de lithium (LiNbO₃) de coupe X. Notons que la coupe Z du cristal de niobate de lithium est également une alternative. D'autres matériaux sont possibles pour cette application, notamment le tantalate de lithium (LiTaO₃) le phosphure d'indium (InP), l'arséniure de gallium (GaAs), les polymères électro-optiques ou encore le silicium dans certaines configurations.

Dans la présente description, on choisit à titre d'exemple d'illustration non-limitatif un substrat de niobate de lithium (LiNbO₃ en coupe X). Le modulateur électro-optique 55 comporte un circuit optique intégré complexe de guides d'onde optiques. Plus précisément, le modulateur électro-optique 55 comporte deux interféromètres de Mach-Zehnder disposés en parallèle, dits, par la suite, interféromètres Mach-Zehnder secondaires, eux-mêmes contenus dans un interféromètre de Mach-Zehnder dit principal. L'interféromètre principal de Mach-Zehnder comporte un guide d'onde optique d'entrée 57 suivi d'une première jonction 58 en forme de Y (ou « Y-junction » en anglais) séparant le guide d'onde optique d'entrée 57 en deux premières branches parallèles. Sur chaque branche parallèle de l'interféromètre principal est formé un interféromètre Mach-Zehnder secondaire. A cet effet, deux autres jonctions Y 59 séparent chacune l'une des deux branches parallèles de l'interféromètre principal pour former au total quatre bras parallèles 60. Au bout d'une certaine longueur, chaque paire de bras 60 se termine par une autre jonction Y 159. En sortie de deux jonctions Y 159 se trouvent les deux branches 61 parallèles de l'interféromètre principal. Une dernière jonction Y 158 joint les deux banches 61 parallèles pour former un guide d'onde optique de sortie 157. Des électrodes sont disposées de part et d'autre des guides d'onde optiques afin de permettre l'application d'une tension électrique qui, par effet électro-optique dans le cristal, modifie l'indice de réfraction du matériau ce qui, par conséquence directe, module la phase de la lumière guidée dans les différents bras. Chaque interféromètre Mach-Zehnder secondaire est muni d'électrodes RF 62a et 62b pour l'application d'un signal micro-onde à chaque interféromètre Mach-Zehnder secondaire et d'électrodes latérales 162a, 162b, 162c reliées à la terre. Chaque interféromètre Mach-Zehnder secondaire peut être également équipé d'électrodes basse fréquence 63a, 63b permettant l'application d'une tension continue afin d'ajuster la phase statique entre les bras 60, et d'électrodes latérales 163a, 163b, 163c reliées à la terre. L'interféromètre principal comporte aussi des électrodes basse fréquence 64a, 64, 64b permettant l'ajustement de la phase statique entre les sorties des deux interféromètres Mach-Zehnder secondaires.

Une source laser monochromatique génère un faisceau laser 65 de fréquence optique ωo représenté schématiquement par une raie sur la figure 5. La raie 65 représente le faisceau laser initial. Le faisceau laser 65 est couplé optiquement dans le guide d'onde d'entrée 57 du modulateur électro-optique 55.

On applique une tension de biais, de préférence continue, sur l'électrode 63a, 63b de chaque interféromètre Mach-Zehnder secondaire. De façon avantageuse, la tension de biais est ajustée de manière à introduire un déphasage de -π radians entre les bras 60 de chaque interféromètre Mach-Zehnder secondaire. Ceci équivaut à placer chaque interféromètre Mach-Zehnder secondaire dans un état bloquant pour la transmission au repos de la lumière incidente. Ce déphasage optique de ±π a pour effet d'annuler la composante du signal optique à la fréquence optique initiale, autrement dit de supprimer le faisceau à la fréquence optique initiale ωo sur le guide d'onde de sortie 157. On applique ensuite sur chaque électrode 62a et 62b une tension à une pulsation hyperfréquence Ω, par exemple de 6.8 GHz × 2π. Le signal électrique modulé de pulsation hyperfréquence est appliqué de manière à être en quadrature de phase électrique entre les deux interféromètres Mach-Zehnder secondaires. De préférence, on applique un signal électrique modulé de pulsation hyperfréquence de la forme sin(Ωt) sur l'électrode 62a et, respectivement, un signal hyperfréquence de la forme cos(Ωt) sur l'électrode 62b, où Ω représente une pulsation hyperfréquence. Les amplitudes respectives des signaux électriques modulés de pulsation hyperfréquence appliqués aux deux interféromètres Mach-Zehnder secondaires sont identiques. Par ailleurs, on ajuste la tension appliquée à l'électrode 64 de l'interféromètre Mach-Zehnder principal de manière à appliquer un déphasage optique de π/2 entre les sorties des deux interféromètres Mach-Zehnder secondaires. En sortie du modulateur électro-optique 55, on obtient ainsi un faisceau laser de sortie ayant une unique raie latérale 66 centrée sur une fréquence optique ωο+Ω. La commutation de la phase de l'interféromètre Mach-Zehnder principal de +π/2 à -π/2 produit une commutation de la fréquence optique du faisceau laser de sortie de ωο+Ω vers ωο-Ω. Autrement dit, le modulateur électro-optique 55 permet de décaler la fréquence optique du faisceau laser d'un décalage égal en valeur absolue à la pulsation hyperfréquence Ω par rapport à fréquence optique initiale ωo du faisceau laser incident sur le modulateur BLU 55 tout en supprimant le faisceau à la fréquence optique initiale ωo en sortie de ce modulateur BLU 55. Il existe une amplitude optimale du signal électrique modulé de pulsation hyperfréquence appliqué sur les électrodes 62a, 62b permettant de maximiser l'amplitude relative de l'unique raie latérale 66 ainsi créée. A son maximum, la raie latérale 66 a une puissance égale à 33,8% de la puissance contenue dans la raie 65 du faisceau laser de fréquence optique ωo incidente sur le modulateur électro-optique 55. De plus, cette raie laser 65 à la fréquence optique ωo est totalement atténuée en sortie du modulateur électro-optique 55. Le taux de réjection de la raie 65 est de l'ordre de -30 dB, indépendamment de l'amplitude des signaux électriques modulés de pulsation hyperfréquence appliqués, contrairement à ce qui se passe avec un modulateur optique de phase, où de nombreuses raies parasites apparaissent. D'une manière plus générale, on constate que tous les ordres situés sur les raies d'ordre pair sont supprimés, avec un taux de réjection de -50 dB, c'est-à-dire les raies aux fréquences optiques wo ±2mΩ où m représente un nombre entier naturel m=0, 1, 2.... Ainsi, pratiquement une seule raie résiduelle latérale 67 subsiste à la fréquence optique ωο-3Ω, dont la puissance relative représente environ 3% de la puissance de la raie latérale 66 centrée sur ωο+Ω. Le modulateur électro-optique 55 permet ainsi une amélioration très significative concernant la réjection de raies résiduelles à la différence d'un modulateur électro-optique de phase qui génère une multitude de raies parasites indésirables à toutes les harmoniques de la modulation, et dont la principale raie parasite présente une puissance relative de 100% par rapport à la bande latérale utile et dont les autres raies latérales les plus proches sont situées à wo±2Q et ont une puissance relative de 40% des deux raies latérales situées à ωο±Ω.

Nous avons décrit l'application d'un signal électrique modulé de pulsation hyperfréquence unique Ω sur les électrodes 62a, 62b du modulateur électro-optique 55.

La présente divulgation propose un fonctionnement particulier et contre-intuitif du modulateur électro-optique à bande latérale unique 55 avec application simultanée de deux signaux hyperfréquence, comme cela est décrit en lien avec la figure 6. Le fonctionnement du modulateur électro-optique 55 est ensuite généralisé à l'application simultanée d'une pluralité de signaux hyperfréquence, ladite pluralité comprenant trois, quatre ou plus signaux hyperfréquence de fréquences distinctes. Un faisceau laser comportant une ou plusieurs raies spectrales simultanées peut être utilisé dans des applications de spectroscopie d'atomes, d'ions ou de molécules.

Sur la figure 6, on applique simultanément deux signaux hyperfréquence sur les électrodes hyperfréquence 62a, 62b de chaque interféromètre Mach-Zehnder secondaire. Plus précisément, on applique un premier signal radiofréquence à une première pulsation hyperfréquence, notée Ω₁, et un deuxième signal radiofréquence à une deuxième pulsation hyperfréquence, notée Ω₂ tout en respectant le critère de quadrature de phase électrique entre les signaux appliqués sur l'électrode 62a et sur l'électrode 62b des deux interféromètres Mach-Zehnder secondaires. Par exemple, on applique un signal électrique doublement modulé à deux pulsations hyperfréquence égal à sin(Ω₁t)+sin(Ω₂t) sur l'électrode 62a et, respectivement, un autre signal électrique doublement modulé à deux pulsations hyperfréquence égal à cos(Ω₁t)+cos(Ω₂t) sur l'électrode 62b. Le déphasage électrique appliqué sur les électrodes basse fréquence 63a, 63b est ajusté à ±π de manière à supprimer le faisceau à la fréquence optique ωo. Cette configuration permet de générer deux raies latérales 68, 69 du même côté de la fréquence optique initiale ωo avec une très forte réjection des autres raies harmoniques, l'énergie se répartissant entre les deux raies 68 et respectivement 69 ainsi générées aux fréquences optiques ωο+Ω₁ et respectivement ωο+ Ω₂. Au maximum d'efficacité, chaque raie latérale 68, 69 recouvre 33,8/2=16,9% de la puissance contenue dans le faisceau laser 65 à la fréquence optique initiale ωo incident sur le modulateur électro-optique 55. A titre d'exemple non limitatif, les pulsations hyperfréquence Ω₁ et Ω₂ sont situées dans une gamme entre 1 GHz et 20 GHz.

Ainsi, le modulateur électro-optique 55 est adapté pour produire simultanément deux raies latérales 68, 69 et pour commuter ces raies latérales suivant une séquence de changements de fréquences optiques destinée à un système d'interféromètre à atomes froids, tel que décrit en lien avec le diagramme de la figure 1. Un générateur hyperfréquence programmable, à deux canaux de sortie, ajustables en amplitude et en fréquence, est configuré pour synchroniser les deux canaux à partir d'une horloge de référence unique. De préférence, le générateur hyperfréquence est configuré pour contrôler la phase électrique relative des deux canaux hyperfréquence sur les électrodes hyperfréquence 62a, 62b, ce qui est nécessaire pour les applications d'interférométrie atomique.

Selon le déphasage électrique, de préférence en quadrature, entre les signaux électriques appliqués sur les électrodes 62a, 62b et la tension appliquée à l'électrode 64 de l'interféromètre Mach-Zehnder principal de manière à obtenir appliquer un déphasage optique de ±π/2 entre les sorties des deux interféromètres Mach-Zehnder secondaires, le modulateur électro-optique 55 génère simultanément deux raies latérales simultanées à ωo + Ω₁ et respectivement ωο+ Ω₂, ou deux raies latérales à ωo - Ω₁ et respectivement ωo- Ω₂.

En outre, le modulateur électro-optique 55 peut recevoir différentes longueurs d'onde optiques. Il peut être configuré par construction pour travailler dans une gamme de longueurs d'onde situées autour de 850 nm ou de 780 nm. Dans ce cas, le modulateur électro-optique 55 peut directement piloter une chambre d'expérience 8 contenant des atomes de césium et dont la raie laser de transition principale est égale à 852 nm. L'application de modulation dite BLU comme décrit en lien avec les figures 6 et 7 à 9.2 GHz correspondant à la transition entre les niveaux hyperfins du césium, permet la réalisation d'une source laser modulable en fréquence optique pour interféromètre à atomes de césium. Une telle configuration, à condition de disposer d'une source laser initiale à 852 nm stable et fine (c'est-à-dire ayant une largeur de raie inférieure à 1 MHz), permet de s'affranchir de composants tels qu'un doubleur de fréquence de type PPLN.

Néanmoins, pour une application à des atomes rubidium, la longueur d'onde de la transition principale est plus courte (780.24 nm) et il est préférable de recourir à une source laser à 1560 nm doublée en fréquence optique au moyen d'un composant optique non-linéaire doubleur de fréquence de type PPLN.

Le résultat du doublage de fréquence illustré sur la figure 7 peut cependant être fortement perturbé par cette opération. Une source laser monochromatique génère un faisceau laser ayant une raie 65 située par exemple à la longueur d'onde 1560 nm. Le faisceau laser éclaire le modulateur électro-optique 55. L'un des deux interféromètres Mach-Zehnder secondaires est modulé par deux signaux électriques modulés, chacun selon une fonction en cosinus du temps, avec deux pulsations hyperfréquence Ω₁ et Ω₂, respectivement : cos (Ω₁.t) +cos (Ω₂.t). L'autre interféromètre Mach-Zehnder secondaire est modulé de manière analogue par les deux mêmes signaux hyperfréquences mais en quadrature par rapport au premier interféromètre Mach-Zehnder secondaire, c'est-à-dire avec une fonction en sinus du temps : sin (Ω₁.t) +sin (Ω₂.t).

De manière générale, l'amplitude d'une des deux pulsations hyperfréquence Ω₁ et Ω₂ diffère de l'autre dans un rapport K. Une tension continue appliquée sur les électrodes 63a, 63b pour régler la phase statique des deux interféromètres Mach-Zehnder secondaires sur -π radians, celle de l'interféromètre Mach-Zehnder principal étant réglée sur π/2. En sortie de modulateur électro-optique 55, on obtient alors deux raies latérales 68 et 69 décalées par rapport à la raie laser initiale qui est elle-même totalement atténuée comme décrit en lien avec la figure 6. Les deux raies latérales 68 et respectivement 69 localisées en ωο+Ω₁ et respectivement ωο+Ω₂ ont une amplitude qui diffère dans un rapport K en amplitude du champ lumineux, et dans un rapport K² en puissance optique de chacune des raies. La commutation de la phase optique de l'interféromètre Mach-Zehnder principal de +π/2 à -π/2 produit une commutation des fréquences optiques des deux raies latérales 68 et respectivement 69 localisées en ωο-Ω₁ et respectivement ωο-Ω₂.

Un composant optique non-linéaire 48 est disposé en cascade derrière le modulateur électro-optique 55. Le composant optique non-linéaire 48 a pour effet de doubler, par effet optique non linéaire et génération de seconde harmonique, toutes les fréquences optiques qui le traversent, en produisant un champ lumineux correspondant au carré de l'ensemble des composants du champ lumineux qui le traverse.

La fréquence optique du signal étant doublée, la longueur d'onde optique est alors divisée par deux. Lorsque le doubleur de fréquence 48 reçoit un faisceau laser à la longueur d'onde de 1560 nm, le rayonnement transmis est converti à la longueur d'onde de 780 nm, qui correspond précisément à la longueur d'onde de transition des atomes de rubidium que l'on cherche à produire.

Sur la figure 7, deux faisceaux continus de fréquence optique ωο+Ω₁ et ωο+Ω₂ et d'amplitudes relatives de champ égales à 1 et K respectivement, traversent le composant optique non-linéaire doubleur de fréquence 48. L'harmonique 70 à la fréquence optique ωο-3Ω₁ et, respectivement, l'harmonique 71 à la fréquence optique ωο-3Ω₂ sont d'amplitude très faible. Par élévation au carré de la somme des deux signaux fréquence optique ωο+Ω₁ et ωο+Ω₂, on obtient alors en sortie du PPLN (voir insert à droite sur la fig. 7) trois composantes: une première composante spectrale 72 centrée sur la fréquence optique doublée en 2ωο+2Ω₁ d'amplitude 1, une deuxième composante spectrale 73 correspondant au terme croisé des deux champs est situé sur la fréquence optique 2ωο+Ω₁+Ω₂ d'amplitude 4K et enfin une troisième composante spectrale 74, qui est centrée sur la fréquence optique doublée 2ωο+2Ω₂ d'amplitude relative K². La figure 7 représente schématiquement l'écart en fréquence optique entre les deux raies principales 68 et 69, qui est de Ω₂-Ω₁ avant doublage en fréquence et qui est conservé après doublage en fréquence entre les composantes spectrales 72 et 73. La troisième composante spectrale 74 à 2ωο+2Ω₂ est fortement atténuée et peut devenir négligeable par rapport aux deux composantes spectrales principales.

Si l'on considère ainsi les puissances lumineuses produites, la puissance des deux raies principales 72, 73 est égale lorsque la condition suivante est satisfaite: 4K=1, soit en amplitude de champ, un rapport K=0,25 entre les raies latérales 68, 69 en sortie du modulateur électro-optique 55. Dans ce cas, la troisième composante spectrale 74 à 2ωο+2Ω₂ de puissance K² ne représente plus que 6% environ de la puissance des deux raies principales 72, 73. On peut ainsi contrôler l'amplitude et la puissance des raies principales produites en sortie du doubleur de fréquence 48 en adaptant le paramètre K d'amplitude relative de modulation entre les deux signaux électriques modulés. On peut maximiser la dynamique en ajustant les indices de modulation de chacune des pulsations hyperfréquence de manière à ce que la somme des puissances des deux raies latérales 68, 69 en sortie du modulateur 55 BLU soit égale à 33,8% de la puissance du faisceau laser incident, à la fréquence optique initiale ωo. Cette valeur constitue une limite et toute augmentation de la puissance électrique appliquée sur le modulateur se traduit par une diminution de l'amplitude de ces raies latérales au profit d'autres raies latérales d'ordre supérieur, ce qui peut être préjudiciable au bon fonctionnement du système.

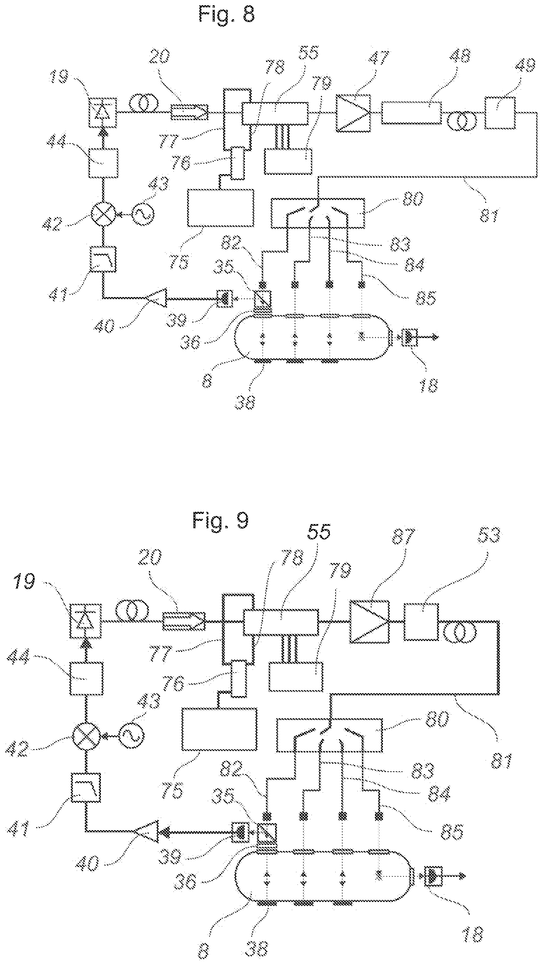

La figure 8 représente schématiquement un système interférométrique à atomes froids comprenant un système de source laser basé sur l'utilisation d'un modulateur électro-optique 55 en combinaison avec un synthétiseur hyperfréquence et, en option, d'un composant optique non-linaire doubleur de fréquence.

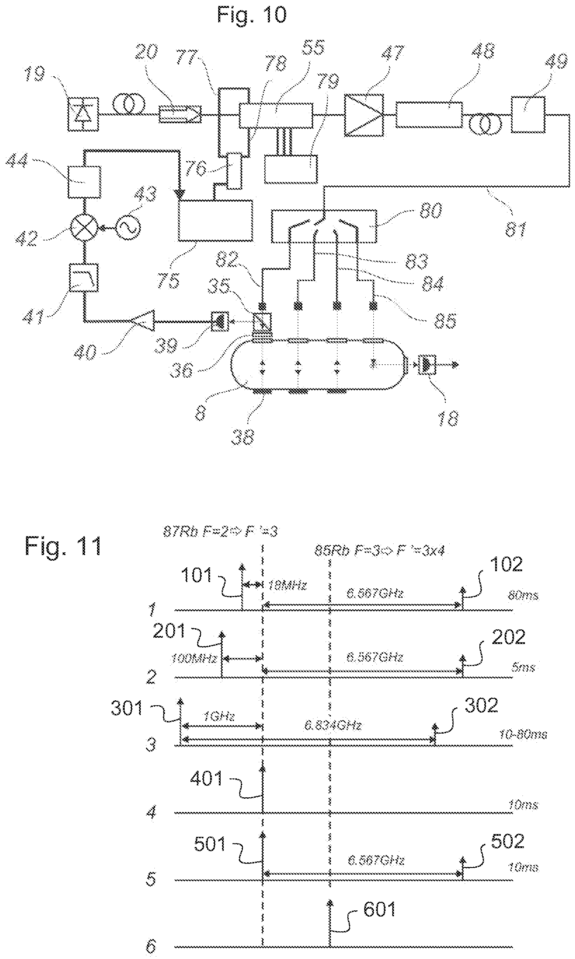

Ce système de source laser a l'avantage de présenter un fort taux de réjection de toutes les raies parasites par comparaison à ce qui est produit avec les sources laser issues de l'art antérieur. Le système de source laser pour interféromètre atomique de la présente divulgation est plus simple et plus compact que les systèmes de l'art antérieur. Le modulateur électro-optique 55 permet en effet de commander la génération de raies latérales de manière reconfigurable selon une séquence donnée en exemple sur la figure 2 ou sur la figure 11.

Le système de source laser illustré sur la figure 8 comporte une source laser 19 à semi-conducteur ou à fibre et un modulateur électro-optique 55. Il est important de noter qu'il n'est pas nécessaire que cette source laser 19 soit ajustable en longueur d'onde. En effet le modulateur électro-optique 55 fournit l'agilité et l'accordabilité du système de source laser. De plus, le modulateur électro-optique 55 permet de compenser un écart en longueur d'onde de la source laser 19 par rapport à la transition atomique considérée, à l'intérieur de la bande passante de modulation du modulateur électro-optique 55, qui est de l'ordre de plusieurs dizaines de GHz ou de 0.05 à 0.1 nm en longueur d'onde.

Dans un mode de réalisation particulier, la source laser 19 n'est pas accordable. Selon un aspect particulier et avantageux, un signal de sortie de l'électronique de contre-réaction 44 est dirigé vers un synthétiseur de fréquences 75. Cette boucle de contre réaction (19, 35, 36, 38, 39, 40, 41, 42, 43, 44) peut même être totalement supprimée si la fréquence optique ωo de la source laser est stable. Dans ce dernier cas, un pré-calibrage des pulsations hyperfréquence générées par le synthétiseur de fréquence 75 est suffisant.

Le modulateur électro-optique 55 est placé en cascade, en sortie de la source laser 19 et de l'isolateur optique 20. Le modulateur électro-optique 55 est piloté par un synthétiseur de fréquences 75 lui-même commandé électroniquement. Le synthétiseur de fréquence 75 est configuré pour générer un signal électrique modulé à une pulsation hyperfréquence ou une pluralité de signaux électriques modulés à plusieurs pulsations hyperfréquences synchronisés sur une même référence d'horloge. Ces signaux électriques modulés de pulsation hyperfréquences sont ajustables et commutables rapidement, y compris en amplitude, par exemple suivant la séquence du diagramme de la figure 11.

Le signal électrique modulé de pulsation hyperfréquence constitué d'une ou de plusieurs modulations sinusoïdales est connecté à un coupleur hybride 76 à large bande spectrale. Le coupleur hybride 76 comporte deux ports de sorties électriques 77, 78 qui sont, par construction, toujours en quadrature (ou à 90 degrés) l'un par rapport à l'autre. Un des ports de sortie 77 du coupleur hybride 76 fournit ainsi un signal électrique modulé de pulsation hyperfréquence avec une dépendance en sinus du temps de chaque signal électrique modulé, tandis que l'autre port 78 est déphasé de 90 degrés par rapport au premier port 77 avec une dépendance en cosinus du temps de chaque signal électrique modulé. Les deux signaux électriques modulés de pulsation hyperfréquence alimentent ainsi en quadrature chaque électrode 62a, respectivement 62b, du modulateur électro-optique 55.

Le modulateur électro-optique 55 est par ailleurs piloté par une électronique de commande et d'asservissement 79, dit aussi contrôleur de biais. Ce contrôleur de biais permet d'asservir, au moyen d'une boucle de contre réaction, les différents états de phase statique du modulateur électro-optique 55, c'est-à-dire -π radian pour les électrodes 63a, 63b des deux interféromètres Mach-Zehnder secondaires, et respectivement de π/2 radian pour l'interféromètre Mach-Zehnder principal. En sortie du modulateur électro-optique 55 est placé un amplificateur optique 47, un doubleur optique de fréquence 48 par exemple de type PPLN, et enfin un modulateur optique d'amplitude 49, par exemple un modulateur acousto-optique qui remplit une fonction d'interrupteur optique de flux lumineux. De façon alternative, le modulateur optique d'amplitude 49 peut être également placé avant le doubleur optique de fréquence PPLN 48. Un commutateur optique 80 contrôlable à une entrée et N sorties (ou 1xN) est placé en cascade en sortie du système et en amont de la chambre d'expérience 8. Le commutateur optique 80 est de préférence un commutateur à base de MEMS. Le commutateur optique 80 permet d'adresser le faisceau optique en provenance d'une fibre optique d'entrée 81 vers, par exemple, l'une des N fibres optiques de sorties 82, 83, 84 et 85. Dans l'exemple représenté, on considère à titre d'exemple quatre sorties. Ces fibres optiques permettent d'éclairer la chambre d'expérience 8 suivant une séquence de commutation de fréquences optiques, par exemple telle que décrite en lien avec la figure 1 ou la figure 11. Ainsi le faisceau sur la sortie 83 est utilisé pour le refroidissement des atomes, le faisceau sur la sortie 84 peut être mis en oeuvre pour la réalisation de l'interféromètre et de ses trois impulsions successives π/2, π et π/2, le faisceau sur la sortie 85 peut être utilisé pour l'interrogation par fluorescence du nuage d'atomes en situation d'interférences et pour la mesure de fluorescence par la photodiode 18 afin de connaitre la phase des interférences produites.

Selon un aspect particulier, un asservissement du système de source laser est effectué par intermittence et non plus de manière continue. A cet effet, le faisceau sur la sortie 82 est utilisé pour contrôler la longueur d'onde du laser 19 par une boucle de contre-réaction. L'asservissement consiste à sonder de manière ponctuelle une transition atomique de référence des atomes pour recalibrer très précisément la fréquence optique de la source laser par rapport à cette transition atomique de référence.

Le système de source laser de la présente divulgation permet d'effectuer une mesure de la dérive de fréquence optique de la source laser 19 de manière intermittente, par exemple périodique, contrairement à l'art antérieur où la fréquence optique de la source est asservie de manière continue en fonction du temps.

Le système de source de la présente divulgation ne nécessite pas de branche spécifique pour le contrôle permanent de la longueur d'onde du laser contrairement au système de la figure 3.

Le système de source de la présente divulgation ne requiert pas de filtre optique accordable complexe, contrairement au système de la figure 4, par exemple.

Ainsi, on propose d'effectuer un contrôle intermittent, avec une seule bande latérale (ou fréquence optique) pour sonder une transition énergétique hyperfine de référence pour le rubidium et re-calibrer la fréquence de la source laser. Ce contrôle intermittent peut être appliqué dans une cellule séparée destinée à ce contrôle ou dans la même enceinte à vide contenant les atomes de l'expérience d'interférométrie atomique.

Ainsi, sur la figure 8, le faisceau 82 permet, de manière intermittente, l'asservissement de la fréquence optique de la source laser 19 sur la transition du gaz d'atomes, directement dans la chambre d'expérience 8, au moyen du séparateur optique 35, de la lame quart d'onde 36, du miroir 38, du détecteur 39, d'un amplificateur optique 40, d'un filtre 41, d'un combineur 42 pour mélanger le signal basse fréquence détecté avec le signal source en provenance du générateur 43. Le signal d'erreur qui résulte de ce traitement peut être traité par un système électronique 44 pour être appliqué comme correction intermittente, autrement dit discrète, aux dérives lentes du laser 19. Dans une telle configuration, un seul laser semi-conducteur 19 peut être utilisé au lieu de deux sources laser en configuration maître-esclave, ce qui simplifie la configuration générale.

Ce système permet ainsi un verrouillage dynamique de la source laser : une raie laser unique est appliquée pour sonder la transition 85Rb F=3 => F'=3x4 de manière à asservir la source laser par rapport à cette bande d'absorption étroite et dont la valeur est connue de manière absolue et très précisément. Cette étape permet un verrouillage intermittent, à la demande.

La figure 9 représente une variante de la figure 8 dans laquelle la source laser 19 est une source laser à semi-conducteur dont la longueur d'onde d'émission est proche de la longueur d'onde de transition des atomes mis en oeuvre dans l'expérience. C'est le cas d'une source optique à semi-conducteur ayant une longueur d'onde d'émission proche de 852 nm qui correspond à la transition des atomes de césium. Le modulateur électro-optique 55 BLU est ici adapté spécifiquement par construction pour fonctionner à cette autre longueur d'onde de 852 nm. Dans ce cas, le système ne comporte pas de composant optique non linéaire 48 de type PPLN doubleur de fréquence ou générateur de deuxième harmonique. Il n'existe pas d'amplificateur optique à fibre optique à cette longueur d'onde. Néanmoins, on remplace l'amplificateur à fibre optique 47 du système illustré en figure 8 par un amplificateur optique 87 à semi-conducteur (SOA) opérant dans la fenêtre de longueur d'onde autour de 850 nm. L'asservissement intermittent permet de compenser les dérives lentes de la fréquence optique de la source laser à semi-conducteur entre deux expériences d'interférométrie atomique.

La figure 10 représente une autre variante de la figure 8 dans laquelle la source laser 19 n'est pas accordable. Par exemple, la source laser 19 est une source laser à fibre optique, dont la fréquence optique est extrêmement stable. On utilise alors pleinement l'agilité en fréquence optique du modulateur électro-optique 55 BLU. A la différence du système illustré en figure 8, le signal de sortie de l'électronique de contre-réaction 44 est dirigé vers le synthétiseur de fréquences 75 pour ajuster la première pulsation Ω₁ et/ou la deuxième pulsation Ω₂.

Dans une autre variante, la boucle de contre réaction sur la source laser 19 peut être supprimée si la fréquence optique de la source laser est suffisamment stable pour rester dans la gamme de fonctionnement du modulateur électro-optique 55 BLU.

### Procédé

Nous allons maintenant décrire une séquence d'interactions entre un système laser tel que décrit ci-dessus et un nuage d'atomes, et plus particulièrement dans une application à l'interférométrie à atomes froids et à impulsions laser.

La figure 11 illustre à titre d'exemple, l'état des raies de la source laser commutable qui peuvent être appliquées, au cours des différentes étapes d'une séquence, sur le gaz d'atomes alcalins, par exemple de rubidium, dont on souhaite ralentir les atomes afin de réaliser des opérations d'interférences à ondes de matière. Les principales étapes 1 à 6 sont décrites à titre d'illustration, afin de donner les ordres de grandeur concernés, en particulier en ce qui concerne les valeurs des fréquences optiques des différentes raies par rapport à la fréquence optique initiale de référence. La fréquence optique initiale ωo est située à une fréquence inférieure à toutes les raie 101, 201, 301, 401, 501, 601 de manière à générer les raies 101, 201, 301, 401, 501, 601 par décalage variable de + Ω₁ et, respectivement, les raies 102, 202, 302, 502 par décalage variable de + Ω₂ par rapport à la fréquence initiale ωo. De manière alternative, la fréquence optique initiale ωo est située à une fréquence supérieure toutes les raie 102, 202, 302, 401, 502, 601 de manière à générer les raies 101, 201, 301, 401, 501, 601 par décalage variable de -Ω₁ et, respectivement, les raies 102, 202, 302, 502 par décalage variable de - Ω₂ par rapport à la fréquence initiale ωo. De plus, la fréquence initiale ωo est sélectionnée de manière à ce que les valeurs maximales de Ω₁ et Ω₂ restent inférieures à 100 GHz. Les deux fréquences optiques étant décalées dans le même sens par rapport à la fréquence optique initiale ωo, celle-ci ne peut pas être située à une fréquence comprise entre 2 raies simultanées, comme par exemple entre les raies 101 et 102, entre les raies 201 et 202, entre les raies 301 et 302 ni entre les raies 501 et 502.

La première étape 1 correspond au piégeage magnéto-optique (MOT: Magneto-optic Trap): en général deux raies laser sont appliquées simultanément dans chaque faisceau 9. Une première raie laser 101 est positionnée à une fréquence optique située 18 MHz en dessous de la transition de référence ⁸⁷Rb F=2 => F'=3 représentée par une ligne tiretée verticale tandis que l'autre raie laser 102 est positionnée avec un écart de 6,567GHz au dessus de cette transition de référence.

La deuxième étape 2 dite de mélasse nécessite une première raie laser 201 décalée cette fois de 100MHz en dessous de la transition de référence tandis que l'autre raie 202 conserve la position de la raie 102, à 6,567GHz au dessus de la transition de référence.

Dans une application à l'interférométrie à atomes froids et à impulsions laser, on applique ensuite les étapes 3 et 4. Ces étapes ne sont toutefois pas indispensables dans d'autres applications, comme par exemple la spectroscopie d'atomes, d'ions ou de molécules.

La troisième étape 3 est celle de l'interféromètre et correspond à l'étape dite de pompage Raman à deux photons qui se déroule en trois temps dits (π/2, π, π/2). La première raie 301 est décalée de 1GHz en dessous de la fréquence de référence et cette fois, l'écart entre les deux raies 301 et 302, nécessaires au pompage Raman, correspond à la transition absolue du niveau hyperfin F=1 => F=2 de 6,834 GHz. De plus, il est nécessaire de contrôler la phase entre les deux fréquences optiques des raies 301 et 302 dans cette étape 3 en contrôlant la phase entre les signaux cos(Ω₁ t) et cos (Ω₂ t) et, respectivement, entre les signaux sin (Ω₁ t) et sin (Ω₂ t) au moyen du système électronique 75 et 76.

La quatrième étape, 4, est la première partie de la détection de l'interférence par fluorescence: une seule raie 401 est positionnée exactement sur la transition ⁸⁷Rb F=2 => F'=3, en vue de compter le nombre d'atomes dans le premier état.

L'étape 5 correspond à la deuxième partie de la détection de l'interférence: deux raies 501, respectivement 502, sont positionnées pour compter le nombre total d'atomes dans les deux états *g* et *e*. En interférométrie atomique, on déduit des étapes 4 et 5 deux mesures successives l'état de la figure d'interférence par fluorescence. Toutefois, dans certaines expériences, l'étape 5 peut être réalisée sans l'étape 4.

La présente divulgation propose une étape 6 supplémentaire qui est une étape d'asservissement appliquée de manière intermittente, avec une seule fréquence optique pour sonder une transition atomique de référence du Rubidium et re-calibrer la fréquence ωo de la source laser. A cet effet, on prélève séquentiellement (par exemple via un commutateur) le faisceau laser pour venir sonder une autre transition atomique de référence uniquement à un instant précis (étape 6) et non pas de manière continue pendant les étapes 1 à 5. On obtient ainsi un verrouillage discret dans le temps, qui remplace avantageusement le verrouillage continu de l'art antérieur.

La figure 11 illustre la grande agilité du rayonnement émis par la source laser et appliqué à la chambre d'expérience qui permet de commuter en des temps très courts d'une raie vers l'autre avec des sauts de plusieurs dizaines à plusieurs centaines de MHz selon les étapes de la séquence. Aux étapes 1, 2, 3 et 5 deux raies simultanées à la fréquence optique ωο+Ω₁ et respectivement ωο+Ω₂ sont présentes tandis que les étapes 4 et 6 imposent une raie unique à une autre fréquence optique décalée ωο+Ω. A partir d'un laser source présentant une raie unique calée par rapport à une référence absolue, la source laser offre une grande flexibilité et une grande agilité de reconfiguration, permettant de dédoubler et d'ajuster extrêmement précisément le décalage entre la ou les deux fréquences optiques et la référence absolue, sans générer de raies parasites.

Plus généralement, les étapes 1, 2 et 5 peuvent être utilisées dans d'autres applications d'interaction entre laser et espèces chimiques, sans mettre en oeuvre les étapes 3 et 4 d'interférométrie, par exemple pour des mesures de spectroscopie sur des atomes, ions ou molécules.

## Revendications

1. Dispositif d'interaction entre un faisceau laser et une transition énergétique hyperfine d'une espèce chimique disposée dans un espace sous vide, comprenant :
- une source laser (19) adaptée pour émettre un faisceau laser source à une fréquence optique initiale (ωo),
**caractérisé en ce que** le dispositif comporte en outre :
- un modulateur électro-optique (55) à bande latérale unique comprenant un guide d'onde optique d'entrée (57) adapté pour recevoir le faisceau laser source et un guide d'onde optique de sortie adapté pour générer un faisceau laser de sortie, le modulateur électro-optique (55) ayant une première électrode haute fréquence (62a), une autre électrode haute fréquence (62b) et une pluralité d'électrodes basse fréquence (63a, 63b, 64),
- un générateur de tension basse fréquence (79), configuré pour appliquer sur chacune desdites électrodes basse fréquence une tension basse fréquence adaptée pour générer un déphasage optique prédéterminé dans le guide d'onde optique, et
- un système électronique (75, 76) comprenant une horloge, le système électronique (75, 76) étant adapté pour générer un premier signal électrique modulé (sin(Ωt), sin(Ω₁t)) à une première pulsation (Ω, Ω₁) et, respectivement, un autre signal électrique modulé (cos(Qt), cos(Q₁t)) à la première pulsation (Ω, Q₁) synchronisés par l'horloge, le système électronique (75, 76) étant adapté pour ajuster en amplitude et en phase le premier signal électrique modulé (sin(Ωt), sin(Ω₁t)) relativement à l'autre signal électrique modulé (cos(Qt), cos(Q₁t)) à la première pulsation (Ω, Ω₁), le système électronique (75, 76) étant adapté pour appliquer simultanément le premier signal électrique modulé (sin(Ωt), sin(Ω₁t)) à la première pulsation (Ω, Ω₁) sur la première électrode haute fréquence (62a) et, respectivement, l'autre signal électrique modulé (cos(Qt), cos(Ω₁t)) à la première pulsation (Ω, Ω₁) sur l'autre électrode haute fréquence (62b), et le système électronique (75, 76) étant adapté pour commuter et accorder la première pulsation (Ω, Ω₁) dans une gamme spectrale hyperfréquence s'étendant au plus sur 100 gigahertz de manière à commuter en fréquence le faisceau laser de sortie vers une première fréquence optique (ωο+Ω, ωο+ Ω₁, ωο-Ω, ωo- Ω₁) décalée de la première pulsation (Ω, Ω₁) par rapport à la fréquence optique initiale (ωo) tout en atténuant le faisceau laser de sortie à la fréquence optique initiale (wo) et aux autres harmoniques de la première pulsation (Ω, Ω₁) par rapport à la fréquence optique initiale (ωo).

2. Dispositif selon la revendication 1 dans lequel le système électronique (75, 76) est adapté pour générer un deuxième signal électrique modulé (sin(Ω₂t)) à une deuxième pulsation (Ω₂) et, respectivement, un autre signal électrique modulé (cos(Ω₂t)) à la deuxième pulsation (Ω₂), le deuxième signal électrique modulé (sin(Ω_{2.}t)) et l'autre signal électrique modulé (cos(Ω₂t)) à la deuxième pulsation (Ω₂) étant synchronisés par l'horloge, le système électronique (75, 76) étant adapté pour ajuster en amplitude et en phase le deuxième signal électrique modulé (sin(Ω₂t)) à la deuxième pulsation (Ω₂) par rapport au premier signal électrique modulé (sin(Ωt), sin(Ω₁t)) à la première pulsation (Ω, Ω₁) et former un premier signal électrique doublement modulé à la première pulsation (Ω, Ω₁) et à la deuxième pulsation (Ω2), le système électronique (75, 76) étant adapté pour ajuster en amplitude et en phase l'autre signal électrique modulé (cos(Ω₂t)) à la deuxième pulsation (Ω2) par rapport à l'autre signal électrique modulé (cos(Ωt), cos(Ω₁t)) à la première pulsation (Ω, Ω₁) et former un autre signal électrique doublement modulé à la première pulsation (Ω, Ω₁) et à la deuxième pulsation (Ω2), et le système électronique (75, 76) étant adapté pour ajuster en déphasage électrique le premier signal électrique doublement modulé par rapport à l'autre signal électrique doublement modulé, et le système électronique (75, 76) étant adapté pour appliquer simultanément le premier signal électrique doublement modulé sur la première électrode haute fréquence (62a) et, respectivement, l'autre signal électrique doublement modulé sur l'autre électrode haute fréquence (62b), et le système électronique (75, 76) étant adapté pour commuter et accorder la deuxième pulsation (Ω2) dans une gamme spectrale hyperfréquence s'étendant au plus sur 100 gigahertz de manière à commuter en fréquence le faisceau laser de sortie simultanément vers la première fréquence optique décalée de la première pulsation (Ω, Ω1) par rapport à la fréquence optique initiale (ωo) et vers une deuxième fréquence optique décalée de la deuxième pulsation (Ω2) par rapport à la fréquence optique initiale (ωo), la première fréquence optique décalée et la deuxième fréquence optique décalée étant décalées dans le même sens par rapport à la fréquence optique initiale (ωo), tout atténuant le faisceau laser de sortie aux autres harmoniques de la deuxième pulsation (Ω2) par rapport à la fréquence optique initiale (ωo).

3. Dispositif selon la revendication 1 dans lequel le système électronique (75, 76) comporte un synthétiseur électronique radiofréquence (75) adapté pour générer un signal électrique modulé à la première pulsation (Ω, Ω₁) et un coupleur hybride (76) ayant un premier canal de sortie (77) et un deuxième canal de sortie (78), le premier canal de sortie (77) étant relié électriquement à la première électrode haute fréquence (62a), et, respectivement, le deuxième canal de sortie (78) étant relié électriquement à l'autre électrode haute fréquence (62b), le coupleur hybride (76) étant adapté pour recevoir le signal électrique modulé à la première pulsation (Ω, Ω₁) et pour générer le premier signal électrique modulé (sin(Ωt), sin(Ω₁t)) à la première pulsation (Ω, Ω₁) sur le premier canal de sortie (77) et, respectivement, l'autre signal électrique modulé (cos(Ωt), cos(Ω₁t)) à la première pulsation (Ω, Ω₁) en quadrature de phase sur le deuxième canal de sortie (78).

4. Dispositif selon les revendications 2 et 3 dans lequel le synthétiseur électronique radiofréquence (75) est adapté pour générer un signal électrique modulé à la deuxième pulsation (Ω₂), le coupleur hybride (76) étant adapté pour recevoir le signal électrique modulé à la deuxième pulsation (Ω₂) et pour générer le deuxième signal électrique modulé (sin(Ω₂t)) à la deuxième pulsation (Ω₂) sur le premier canal de sortie (77) et, respectivement, l'autre signal électrique modulé (cos(Ω₂t)) à la deuxième pulsation (Ω₂) en quadrature de phase sur le deuxième canal de sortie (78).

5. Dispositif selon l'une des revendications 1 à 4 comprenant en outre un composant optique non-linéaire (48) disposé pour recevoir le faisceau laser de sortie à la première fréquence optique décalée de la première pulsation (Ω1) par rapport à la fréquence optique initiale (ωo) et/ou à la deuxième fréquence optique décalée de la deuxième pulsation (Ω2) par rapport à la fréquence optique initiale (ωo), le composant optique non-linéaire (48) étant adapté pour générer un faisceau laser à une fréquence optique double de la première fréquence optique décalée, à une fréquence optique double de la deuxième fréquence optique décalée, et/ou respectivement, à une fréquence optique somme de la première fréquence optique décalée et de la deuxième fréquence optique décalée.

6. Dispositif selon l'une des revendications 1 à 5 comportant en outre un commutateur optique (80), le commutateur optique (80) ayant une voie d'entrée (81) et une pluralité de voies de sortie (82, 83, 84, 85), le commutateur optique (80) étant adapté pour recevoir sur la voie d'entrée et diriger sur l'une des voies de sortie le faisceau laser de sortie à la première fréquence optique décalée de la première pulsation (Ω1) par rapport à la fréquence optique initiale (ωo), le faisceau laser de sortie à la deuxième fréquence optique décalée de la deuxième pulsation (Ω2) par rapport à la fréquence optique initiale (ωo), le faisceau laser à la fréquence optique double de la première fréquence optique décalée, le faisceau laser à la fréquence optique double de la deuxième fréquence optique décalée, et/ou respectivement, le faisceau laser à la fréquence optique somme de la première fréquence optique décalée et de la deuxième fréquence optique décalée.

7. Dispositif selon l'une des revendications 1 à 6 comprenant une boucle électronique de contre-réaction comprenant un photodétecteur (39), une source électrique (43) et un mélangeur de signaux (42), le photodétecteur (39) étant adapté pour mesurer un signal d'absorption par l'espèce chimique (7, 11, 15, 16) du faisceau laser de sortie à la première fréquence optique décalée, à la deuxième fréquence optique décalée, du faisceau laser à la fréquence optique double de la première fréquence optique décalée, du faisceau laser à la fréquence optique double de la deuxième fréquence optique décalée, et/ou respectivement, du faisceau laser à la fréquence optique somme de la première fréquence optique décalée et de la deuxième fréquence optique décalée, la source électrique (43) étant adaptée pour générer un signal basse fréquence et le mélangeur de signaux (42) étant adapté pour mélanger le signal d'absorption et le signal basse fréquence pour former un signal d'erreur.

8. Dispositif selon la revendication 7 dans lequel la boucle électronique de contre-réaction est configurée pour appliquer par intermittence le signal d'erreur à la source laser (19) de manière à ajuster la fréquence optique initiale (ωo) sur une transition énergétique hyperfine de référence de l'espèce chimique.

9. Dispositif selon la revendication 8 dans lequel la boucle électronique de contre-réaction est configurée pour appliquer par intermittence le signal d'erreur au système électronique (75, 76) de manière à ajuster la première pulsation (Ω, Ω₁) et/ou la deuxième pulsation (Ω₂).

10. Dispositif selon l'une des revendications 1 à 9 dans lequel la source laser (19) comprend un laser à semi-conducteur ou un laser à fibre optique.

11. interféromètre à atomes froids et à impulsions laser comprenant un dispositif selon l'une des revendications 4 à 10 dans lequel l'espèce chimique est constituée d'atomes et dans lequel le synthétiseur électronique radiofréquence (75) est adapté pour commuter la première pulsation (Ω1) et la deuxième pulsation (Ω2) suivant une séquence prédéterminée.

12. Appareil de spectrométrie optique hyperfine comprenant un dispositif selon l'une des revendications 1 à 10 dans lequel l'espèce chimique est constituée d'atomes, d'ions ou de molécules et comprenant un détecteur adapté pour mesurer une transition énergétique hyperfine de l'espèce chimique par absorption, réflexion ou diffusion du faisceau laser décalé en fréquence.

13. Procédé d'interaction entre un faisceau laser et une transition énergétique hyperfine d'une espèce chimique comprenant les étapes suivantes :
- confinement de l'espèce chimique (7, 11, 15, 16) dans un espace sous vide (8),
- émission d'un faisceau laser source à une fréquence optique initiale (ωo) ;
- injection du faisceau laser source sur un guide d'onde optique d'entrée (57) d'un modulateur électro-optique (55) à bande latérale unique,
- génération d'un premier signal électrique modulé (sin(Ωt), sin(Ω₁t)) à une première pulsation (Ω, Ω₁) synchronisé sur une horloge et, respectivement, d'un autre signal électrique modulé (cos(Qt), cos(Ω₁t)) à la première pulsation (Ω, Ω₁) synchronisé sur l'horloge, la première pulsation (Ω, Ω₁) étant commutable et ajustable dans une gamme spectrale hyperfréquence s'étendant au plus sur 100 gigahertz,
- ajustement en amplitude et en phase du premier signal électrique modulé (sin(Ωt), sin(Ω₁t)) relativement à l'autre signal électrique modulé (cos(Ωt), cos(Ω₁t)) à la première pulsation (Ω, Ω₁),
- application simultanée du premier signal électrique modulé (sin(Ωt), sin(Ω₁t)) à la première pulsation (Ω, Ω₁) sur une première électrode haute fréquence (62a) du modulateur électro-optique (55) et, respectivement, de l'autre signal électrique modulé (cos(Qt), cos(Q₁t)) à la première pulsation (Ω, Ω₁) sur une autre électrode haute fréquence (62b) du modulateur électro-optique (55) de manière à générer sélectivement, sur un guide d'onde optique de sortie (157) du modulateur électro-optique (55), un faisceau laser de sortie à une première fréquence optique décalée de la première pulsation (Ω, Ω1) par rapport à la fréquence optique initiale (ωo) tout en atténuant le faisceau laser à la fréquence optique initiale (ωo) et aux autres fréquences harmoniques de la première pulsation (Ω, Ω₁) par rapport à la fréquence optique initiale (ωo) et,
- amplification optique (47, 87) du faisceau laser de sortie pour générer un faisceau laser amplifié à la première fréquence optique décalée (ωο+Ω, ωο+ Ω₁, ωο-Ω, ωo- Ω₁), et
- transmission du premier faisceau laser amplifié à la première fréquence optique décalée (ωο+Ω, ωο+ Ω₁) en direction de l'espèce chimique (7, 11, 15, 16) de manière à interagir avec une transition énergétique hyperfine de l'espèce chimique (7, 11, 15, 16).

14. Procédé selon la revendication 13 comprenant en outre les étapes suivantes :
- génération d'un deuxième signal électrique modulé (sin(Ω₂t)) à une deuxième pulsation (Ω₂) synchronisé sur l'horloge et, respectivement, d'un autre signal électrique modulé (cos(Ω₂t)) à la deuxième pulsation (Ω₂) synchronisé sur l'horloge, la deuxième pulsation (Ω₂) étant commutable et ajustable dans une gamme spectrale hyperfréquence s'étendant au plus sur 100 gigahertz,
- ajustement en amplitude et en phase du deuxième signal électrique modulé (sin(Ω₂t)) à la deuxième pulsation (Ω₂) par rapport au premier signal électrique modulé (sin(Ωt), sin(Ω₁t)) à la première pulsation (Ω, Ω1) pour former un premier signal électrique doublement modulé à la première pulsation (Ω, Ω1) et à la deuxième pulsation (Ω₂), et ajustement en amplitude et en phase de l'autre signal électrique modulé (cos(Ω₂t)) à la deuxième pulsation (Ω₂) par rapport à l'autre signal électrique modulé (cos(Ωt), cos(Ω₁t)) à la première pulsation (Ω, Ω1) pour former un autre signal électrique doublement modulé à la première pulsation (Ω, Ω1) et à la deuxième pulsation (Ω₂),
- ajustement de phase électrique du premier signal électrique doublement modulé par rapport à l'autre signal électrique doublement modulé,
- application simultanée du premier signal électrique doublement modulé sur la première électrode haute fréquence (62a) du modulateur électro-optique (55) et, respectivement, de l'autre signal électrique doublement modulé sur l'autre électrode haute fréquence (62b) du modulateur électro-optique (55) de manière à générer sur le guide d'onde optique de sortie (157) du modulateur électro-optique (55), un faisceau laser de sortie commuté simultanément vers la première fréquence optique décalée de la première pulsation (Ω, Ω1) par rapport à la fréquence optique initiale (ωo) et vers une deuxième fréquence optique décalée de la deuxième pulsation (Ω2) par rapport à la fréquence optique initiale (ωo), la première fréquence optique décalée et la deuxième fréquence optique décalée étant décalées dans le même sens par rapport à la fréquence optique initiale (ωo),
- amplification optique (47, 87) du faisceau laser de sortie pour générer un faisceau laser amplifié simultanément à la première fréquence optique décalée (ωο+Ω, ωο+ Ω₁, ωο-Ω, ωo- Ω₁) et à la deuxième fréquence optique décalée, et
- transmission du faisceau laser amplifié simultanément à la première fréquence optique décalée (ωο+Ω, ωο+ Ω₁, ωο-Ω, ωo- Ω₁) et à la deuxième fréquence optique décalée en direction de l'espèce chimique (7, 11, 15, 16).

## Patentansprüche

1. Vorrichtung für eine Wechselwirkung zwischen einem Laserstrahl und einem hyperfeinen Energieübergang einer in einem Vakuumraum platzierten chemischen Spezies mit:
- einer Laserquelle (19), die dafür ausgelegt ist, einen Quellenlaserstrahl mit einer optischen Anfangsfrequenz (ωo) auszusenden,
**dadurch gekennzeichnet, daß** die Vorrichtung außerdem aufweist:
- einen elektrooptischen Einseitenband-Modulator (55) mit einem optischen Eingangswellenleiter (57), der dafür ausgelegt ist, den Quellenlaserstrahl zu empfangen, und einem optischen Ausgangswellenleiter, der dafür ausgelegt ist, einen Ausgangslaserstrahl zu erzeugen, wobei der elektrooptische Modulator (55) eine erste Hochfrequenzelektrode (62a), eine weitere Hochfrequenzelektrode (62b) und mehrere Niederfrequenzelektroden (63a, 63b, 64) aufweist,
- einen Niederfrequenzspannungsgenerator (79), der so ausgelegt ist, daß er an jede der Niederfrequenzelektroden eine Niederfrequenzspannung anlegt, die geeignet ist, eine vorbestimmte optische Phasenverschiebung im optischen Wellenleiter zu erzeugen, und
- ein elektronisches System (75, 76) mit einer Uhr, wobei das elektronische System (75, 76) dafür ausgelegt ist, ein moduliertes erstes elektrisches Signal (sin(Ωt), sin(Ω₁t)) bei einem ersten Impuls (Ω, Ω₁) und in entsprechender Weise ein moduliertes weiteres elektrisches Signal (cos(Ωt), cos(Q₁t)) bei dem ersten Impuls (Ω, Ω₁), die durch die Uhr synchronisiert sind, zu erzeugen, wobei das elektronische System (75, 76) dafür ausgelegt ist, das modulierte erste elektrische Signal (sin(Ωt), sin(Ω₁t)) in Bezug auf das weitere modulierte elektrische Signal (cos(Ωt), cos(Q₁t)) bei dem ersten Impuls (Ω, Ω₁) hinsichtlich der Amplitude und der Phase einzustellen, wobei das elektronische System (75, 76) dafür ausgelegt ist, das modulierte erste elektrische Signal (sin(Ωt), sin(Ω₁t)) bei dem ersten Impuls (Ω, Ω₁) an die erste Hochfrequenzelektrode (62a) und gleichzeitig das weitere modulierte elektrische Signal (cos(Ωt), cos(Q₁t)) bei dem ersten Impuls (Ω, Ω₁) an die weitere Hochfrequenzelektrode (62b) anzulegen, und wobei das elektronische System (75, 76) dafür ausgelegt ist, den ersten Impuls (Ω, Ω₁) in einem Mikrowellenspektralbereich, der sich höchstens über 100 Gigahertz erstreckt, umzuschalten und abzustimmen, um den Ausgangslaserstrahl frequenzmäßig auf eine erste optische Frequenz (ωο+Ω, ωο+Ω₁, ωο-Ω, ωο-Ω₁) des ersten Impulses (Ω, Ω₁) umzuschalten, die gegenüber der optischen Anfangsfrequenz (ωo) verschoben ist, und dabei den Ausgangslaserstrahl mit der optischen Anfangsfrequenz (ωo) und mit den weiteren Harmonischen des ersten Impulses (Ω, Ω₁) gegenüber der optischen Anfangsfrequenz (ωo) zu dämpfen.

2. Vorrichtung gemäß Anspruch 1, bei der das elektronische System (75, 76) dafür ausgelegt ist, ein moduliertes zweites elektrisches Signal (sin(Ω₂t)) bei einem zweiten Impuls (Ω₂) und in entsprechender Weise ein weiteres moduliertes elektrisches Signal (cos(Ω₂t)) bei dem zweiten Impuls (Ω₂) zu erzeugen, wobei das modulierte zweite elektrische Signal (sin(Ω₂t)) und das modulierte weitere elektrische Signal (cos(Ω₂t)) bei dem zweiten Impuls (Ω₂) durch die Uhr synchronisiert sind, wobei das elektronische System (75, 76) dafür ausgelegt ist, das modulierte zweite elektrische Signal (sin(Ω₂t)) bei dem zweiten Impuls (Ω₂) in Bezug auf das modulierte erste elektrische Signal (sin(Ωt), sin(Ω₁t)) bei dem ersten Impuls (Ω, Ω₁) hinsichtlich der Amplitude und der Phase einzustellen und ein doppelt moduliertes erstes elektrisches Signal bei dem ersten Impuls (Ω, Q₁) und bei dem zweiten Impuls (Ω2) zu bilden, wobei das elektronische System (75, 76) dafür ausgelegt ist, das modulierte weitere elektrische Signal (cos(Ω₂t)) bei dem zweiten Impuls (Ω₂) gegenüber dem modulierten weiteren elektrischen Signal (cos(Ωt, cos(Ω₁t)) bei dem ersten Impuls (Ω, Ω₁) hinsichtlich der Amplitude und der Phase einzustellen und ein doppelt moduliertes weiteres elektrisches Signal bei dem ersten Impuls (Ω, Ω₁) und bei dem zweiten Impuls (Ω2) zu bilden, und wobei das elektronische System (75, 76) dafür ausgelegt ist, das doppelt modulierte erste elektrisches Signal in Bezug auf das doppelt modulierte weitere elektrische Signal hinsichtlich der Phasenverschiebung einzustellen, und wobei das elektronische System (75, 76) dafür ausgelegt ist, das doppelt modulierte erste elektrische Signal an die erste Hochfrequenzelektrode (62a) und gleichzeitig das doppelt modulierte weitere elektrische Signal an die weitere Hochfrequenzelektrode (62b) anzulegen, und wobei das elektronische System (75, 76) dafür ausgelegt ist, den zweiten Impuls (Ω₂) in einem Mikrowellenspektralbereich, der sich höchstens über 100 Gigahertz erstreckt, umzuschalten und abzustimmen, um den Ausgangslaserstrahl frequenzmäßig gleichzeitig auf die erste optische Frequenz des ersten Impulses (Ω, Ω₁), die gegenüber der optischen Anfangsfrequenz (ωo) verschoben ist, und auf eine zweite optische Frequenz des zweiten Impulses (Ω₂), die gegenüber der optischen Anfangsfrequenz (ωo) verschoben ist, umzuschalten, wobei die verschobene erste optische Frequenz und die verschobene zweite optische Frequenz gegenüber der optischen Anfangsfrequenz (ωo) in derselben Richtung verschoben sind, und dabei den Ausgangslaserstrahl mit den weiteren Harmonischen des zweiten Impulses (Ω₂) gegenüber der optischen Anfangsfrequenz (ωo) zu dämpfen.

3. Vorrichtung nach Anspruch 1, bei der das elektronische System (75, 76) einen elektronischen Hochfrequenz-Synthesizer (75), der dafür ausgelegt ist, bei dem ersten Impuls (Ω, Ω₁) ein moduliertes elektrisches Signal zu erzeugen, und einen Hybridkoppler (76) mit einem ersten Ausgangskanal (77) und einem zweiten Ausgangsk anal (78) aufweist, wobei der erste Ausgangskanal (77) elektrisch mit der ersten Hochfrequenzelektrode (62a) verbunden ist und entsprechend der zweite Ausgangskanal (78) elektrisch mit der weiteren Hochfrequenzelektrode (62b) verbunden ist, wobei der Hybridkoppler (76) dafür ausgelegt ist, das modulierte elektrische Signal bei dem ersten Impuls (Ω, Ω₁) zu empfangen und das modulierte erste elektrische Signal (Sin(Ωt), sin(Ω₁t)) bei dem ersten Impuls (Ω, Ω₁) auf dem ersten Ausgangskanal (77) und entsprechend das modulierte weitere elektrische Signal (cos(Ωt), cos(Q₁t)) bei dem ersten Impuls (Ω, Ω₁) in Phasenquadratur auf dem zweiten Ausgangskanal (78) zu erzeugen.

4. Vorrichtung gemäß den Ansprüchen 2 und 3, bei der der elektronische Hochfrequenz-Synthesizer (75) dafür ausgelegt ist, ein moduliertes elektrisches Signal bei dem zweiten Impuls (Ω₂) zu erzeugen, wobei der Hybridkoppler (76) dafür ausgelegt ist, das modulierte elektrische Signal bei dem zweiten Impuls (Ω₂) zu empfangen und das modulierte zweite elektrische Signal (sin(Ω₂t)) bei dem zweiten Impuls (Ω₂) auf dem ersten Ausgangskanal (77) und entsprechend das modulierte weitere elektrische Signal (cos(Ω₂t)) bei dem zweiten Impuls (Ω₂) in Phasenquadratur auf dem zweiten Ausgangskanal (78) zu erzeugen.

5. Vorrichtung gemäß einem der Ansprüche 1 bis 4, die außerdem ein nichtlineares optisches Bauelement (48) aufweist, das bereit ist, den Ausgangslaserstrahl bei der ersten optischen Frequenz des ersten Impulses (Ω1), die gegenüber der optischen Anfangsfrequenz (ωo) verschoben ist, und/oder bei der zweiten optischen Frequenz des zweiten Impulses (Ω2), die gegenüber der optischen Anfangsfreuqenz (ωo) verschoben ist, zu empfangen, wobei das nichtlineare optische Bauelement (48) dafür ausgelegt ist, einen Laserstrahl mit einer doppelt so großen optischen Frequenz wie die verschobene erste optische Frequenz, mit einer doppelt so großen optischen Frequenz wie die verschobene zweite optische Frequenz, und/oder entsprechend mit einer optischen Frequenz, die die Summe der verschobenen ersten optischen Frequenz und der verschobene zweiten optischen Frequenz ist, zu erzeugen.

6. Vorrichtung gemäß einem der Ansprüche 1 bis 5, die außerdem einen optischen Umschalter (80) aufweist, wobei der optische Umschalter (80) einen Eingangskanal (81) und eine Anzahl Ausgangskanäle (82, 83, 84, 85) aufweist, wobei der optische Umschalter (80) dafür ausgelegt ist, den Ausgangslaserstrahl bei der ersten optischen Frerequenz des ersten Impulses (Ω1), die gegenüber der optischen Anfangsfrequenz (ωo) verschoben ist, den Ausgangslaserstrahl bei der zweiten optischen Frequenz des zweiten Impulses (Ω2), die gegenüber der optischen Anfangsfrequenz (ωo) verschoben ist, den Laserstrahl bei der optischen Frequenz, die doppelt so groß wie die verschobene erste optische Frequenz ist, und/oder entsprechend den Laserstrahl der optischen Frequenz, die die Summe der verschobenen ersten optischen Frequenz und der verschobenen zweiten Frequenz ist, auf dem Eingangskanal zu empfangen und auf einen der Ausgangskanäle umzuleiten.

7. Vorrichtung gemäß einem der Ansprüche 1 bis 6, die eine elektronische Gegenreaktionsschleife mit einem Fotodetektor (39), einer elektrischen Quelle (43) und einem Signalmischer (42) aufweist, wobei der Fotodetektor (39) dafür ausgelegt ist, pro chemische Spezies (7, 11, 15, 16) ein Absorptionssignal des Ausgangslaserstrahls bei der verschobenen ersten optischen Frequenz, bei der verschobenen zweiten optischen Frequenz, des Laserstrahls bei der optischen Frequenz, die doppelt so groß wie die verschobene erste optische Frequenz ist, und/oder entsprechend des Laserstrahls der optischen Frequenz, die die Summe der verschobenen ersten optischen Frequenz und der verschobenen zweiten Frequenz ist, zu messen, wobei die elektrische Quelle (43) dafür ausgelegt ist, ein Niederfrequenzsignal zu erzeugen, und der Signalmischer (42) dafür ausgelegt ist, das Absorptionssignal mit dem Niederfrequenzsignal zu mischen, um ein Fehlersignal zu bilden.

8. Vorrichtung gemäß Anspruch 7, bei der die elektronische Gegenreaktionsschleife dazu ausgelegt ist, das Fehlersignal in Abständen an die Laserquelle (19) anzulegen, um die optische Anfangsfrequenz (ωo) auf einen hyperfeinen Referenzenergieübergang der chemischen Spezies einzustellen.

9. Vorrichtung gemäß Anspruch 8, bei der die elektronische Gegenreaktionsschleife dafür ausgelegt ist, das Fehlersignal in Abständen an das elektronische System (75, 76) anzulegen, um den ersten Impuls (Ω, Ω₁) und/oder den zweiten Impuls (Ω₂) einzustellen.

10. Vorrichtung gemäß einem der Ansprüche 1 bis 9, bei der die Laserquelle (19) einen Halbleiterlaser oder einen Laser mit optischer Faser aufweist.

11. Interferometer mit kalten Atomen und Laserimpulsen, das eine Vorrichtung gemäß einem der Ansprüche 4 bis 10 aufweist, wobei die chemische Spezies aus Atomen besteht, und bei dem der elektronische Hochfrequenz-Synthesizer (75) dazu ausgelegt ist, den ersten Impuls (Ω1) und den zweiten Impuls (Ω₂) in einer vorgegebenen Reihenfolge umzuschalten.

12. Gerät für hyperfeine optische Spektrometrie mit einer Vorrichtung gemäß einem der Ansprüche 1 bis 10, wobei die chemische Spezies aus Atomen, Ionen oder Molekülen besteht, und einem Detektor, der dafür ausgelegt ist, einen hyperfeinen Energieübergang der chemischen Spezies durch Absorption, Reflexion oder Diffusion des frequenzverschobenen Laserstrahls zu messen.

13. Verfahren für eine Wechselwirkung zwischen einem Laserstrahl und einem hyperfeinen Energieübergang einer chemischen Spezies mit den folgenden Schritten :
- Einschluß der chemischen Spezies (7, 11, 15, 16) in einem Vakuumraum (8),
- Aussenden eines Quellenlaserstrahls mit einer optischen Anfangsfrequenz (ωo);
- Einleiten des Quellenlaserstrahls in einen optischen Eingangswellenleiter (57) eines elektrooptischen Einseitenbandmodulators (55),
- Erzeugen eines modulierten ersten elektrischen Signals (sin(Ωt), sin(Ω₁t)) bei einem ersten Impuls (Ω, Ω₁), das durch eine Uhr synchronisiert ist, und entsprechend eines modulierten weiteren elektrischen Signals (cos(Ωt), cos(Q₁t)) bei dem ersten Impuls (Ω, Ω1), das durch die Uhr synchronisiert ist, wobei der erste Impuls (Ω, Ω₁) in einem Mikrowellenspektralbereich, der sich höchstens über 100 Gigahertz erstreckt, umschaltbar und abstimmbar ist,
- Anpassen der Amplitude und Phase des modulierten ersten elektrischen Signals (sin(Ωt), sin(Ω₁t)) in Bezug auf das modulierte weitere elektrische Signal (cos(Ωt), cos(Ω ₁t)) bei dem ersten Impuls (Ω, Ω ₁ ),
- gleichzeitiges Anlegen des modulierten ersten elektrischen Signals (sin(Ωt), sin(Ω₁t)) bei dem ersten Impuls (Ω, Ω ₁) an eine erste Hochfrequenzelektrode (62a) des elektrooptischen Modulators (55) und entsprechend des modulierten weiteren elektrischen Signals (cos(Ωt), cos(Ω₁t)) bei dem ersten Impuls (Ω, Ω ₁) an eine weitere Hochfrequenzeelektrode (62b) des elektrooptischen Modulators (55), um auf einem optischen Ausgangswellenleiter (157) des elektrooptischen Modulators (55) selektiv einen Ausgangslaserstrahl mit einer verschobenen ersten optischen Frequenz des ersten Impulses (Ω, Ω₁) zu erzeugen, die gegenüber der optischen Anfangsfrequenz (ωo) verschoben ist, während der Laserstrahl mit der optischen Anfangsfrequenz (ωo) und den weiteren harmonischen Frequenzen des ersten Impulses (Ω, Ω 1) gegenüber der optischen Anfangsfrequenz (ωo) gedämpft wird, und
- optische Verstärkung (47, 87) des Ausgangslaserstrahls, um einen verstärkten Laserstrahl mit der verschobenen ersten optischen Frequenz (ωο+Ω, ωο+Ω₁, ωο-Ω, ωο-Ω₁) zu erzeugen, und
- Übermittlung des verstärkten ersten Laserstrahls mit der verschobenen ersten optischen Frequenz (ωο+Ω, ωο+Ω₁) in Richtung auf die chemische Spezies (7, 11, 15, 16), um eine Wechselwirkung mit einem hyperfeinen Energieübergang der chemischen Spezies (7, 11, 15, 16) zu bewirken.

14. Verfahren nach Anspruch 13, das außerdem die folgenden Schritte aufweist:
- Erzeugen eines modulierten zweiten elektrischen Signals (sin(Ω₂t)) bei einem zweiten Impuls (Ω₂), das durch die Uhr synchronisiert ist, und entsprechend eines modulierten weiteren elektrischen Signals (cos(Ω₂t)) bei dem zweiten Impuls (Ω₂), das durch die Uhr synchronisiert ist, wobei der zweite Impuls (Ω₂) in einem Mikrowellenspektralbereich, der sich höchstens über 100 Gigahertz erstreckt, umschaltbar und abstimmbar ist,
- Anpassen der Amplitude und Phase des modulierten zweiten elektrischen Signals (sin(Ω₂t)) bei dem zweiten Impuls (Ω₂) in Bezug auf das modulierte erste elektrische Signal (sin(Ωt), sin(Ω ₁t)) bei dem ersten Impuls (Ω, Ω₁), um ein doppelt moduliertes erstes elektrisches Signal bei dem ersten Impuls (Ω, Ω₁) und bei dem zweiten Impuls (Ω₂) zu erzeugen, und Anpassung der Amplitude und Phase des modulierten weiteren elektrischen Signals (cos(Ω₂t)) bei dem zweiten Impuls (Ω₂) in Bezug auf das modulierte weitere elektrische Signal (cos(Ωt), cos(Q₁t)) bei dem ersten Impuls (Ω, Ω ₁ ), um ein doppelt moduliertes weiteres elektrisches Signal bei dem ersten Impuls (Ω, Ω₁) und bei dem zweiten Impuls (Ω₂) zu erzeugen,
- Anpassen der elektrischen Phase des doppelt modulierten ersten elektrischen Signals gegenüber dem doppelt modulierten weiteren elektrischen Signal,
- gleichzeitiges Anlegen des doppelt modulierten ersten elektrischen Signals an die erste Hochfrequenzelektrode (62a) des elektrooptischen Modulators (55) und entsprechend des doppelt modulierten weiteren elektrischen Signals an die weitere Hochfrequenzeelektrode (62b) des elektrooptischen Modulators (55), um auf dem optischen Ausgangswellenleiter (157) des elektrooptischen Modulators (55) einen Ausgangslaserstrahl zu erzeugen, der gleichzeitig zur ersten optischen Frequenz des ersten Impulses (Ω, Ω₁), die gegenüber der optischen Anfangsfrequenz (ωo) verschoben ist, und zu einer zweiten optischen Frequenz, die gegenüber der optischen Anfangsfrequenz (ωo) verschoben ist, umgeschaltet wird, wobei die verschobene erste optische Frequenz und die verschobene zweite optische Frequenz in Bezug auf die optische Anfangsfrequenz (ωo) in derselben Richtung verschoben sind,
- optische Verstärkung (47, 87) des Ausgangslaserstrahls, um einen verstärkten Laserstrahl zu erzeugen, der gleichzeitig die verschobene erste optische Frequenz (ωο+Ω, ωο+Ω₁, ωο-Ω, ωο-Ω₁) und die verschobene zweite optische Frequenz hat, und
- Übermittlung des verstärkten Laserstrahls, der zugleich die verschobene erste optische Frequenz (ωο+Ω, ωο+Ω₁, ωο-Ω, ωο-Ω₁) und die verschobene zweite Frequenz aufweist, in Richtung auf die chemische Spezies (7, 11, 15, 16).

## Claims

1. A device for interaction between a laser beam and a hyperfine energy transition of a chemical species placed in a vacuum space, comprising:
- a laser source (19) adapted to emit a source laser beam at an initial optical frequency (wo),
**characterized in that** the device further includes:
- a single sideband electro-optic modulator (55) comprising an input optical waveguide (57) adapted to receive the source laser beam and an output optical waveguide adapted to generate an output laser beam, the electro-optic modulator (55) having a first high-frequency electrode (62a), another high-frequency electrode (62b) and a plurality of low-frequency electrodes (63a, 63b, 64),
- a low-frequency voltage generator (79), configured to apply on each of said low-frequency electrodes a low-frequency voltage adapted to generate a predetermined optical phase-shift in the optical waveguide, and
- an electronic system (75, 76) comprising a clock, the electronic system (75, 76) being adapted to generate a first electrical signal (sin(Ωt), sin(Ω₁t)) modulated at a first pulse (Ω, Ω₁) and, respectively, another electrical signal (cos(Ωt), cos(Q₁t)) modulated at the first pulse (Ω, Ω₁), synchronized by the clock, the electronic system (75, 76) being adapted to amplitude and phase-tune the first modulated electrical signal (sin(Ωt), sin(Ω₁t)) with respect to the other electrical signal (cos(Ωt), cos(Q₁t)) modulated at the first pulse (Ω, Ω₁), the electronic system (75, 76) being adapted to simultaneously apply the first electrical signal (sin(Ωt), sin(Ω₁t)) modulated at the first pulse (Ω, Ω₁) to the first high-frequency electrode (62a) and, respectively, the other electrical signal (cos(Ωt), cos(Q₁t)) modulated at the first pulse (Ω, Ω₁) to the other high-frequency electrode (62b), and the electronic system (75, 76) being adapted to switch and tune the first pulse (Ω, Ω₁) in a microwave spectral range extending over at most 100 gigahertz so as to frequency-switch the output laser beam to a first optical frequency (wo+Q, ωο+Ω₁, ωο-Ω, ωο-Ω₁) shifted by the first pulse (Ω, Ω₁) with respect to the initial optical frequency (ωo) while attenuating the output laser beam at the initial optical frequency (ωo) and at the other harmonics of the first pulse (Ω, Ω₁) with respect to the initial optical frequency (ωo).

2. The device according to claim 1, wherein the electronic system (75, 76) is adapted to generate a second electrical signal (sin(Ω₂t)) modulated at a second pulse (Ω₂) and, respectively, another electrical signal (cos(Ω₂t)) modulated at the second pulse (Ω₂), the second modulated electrical signal (sin(Ω_{2.}t)) and the other electrical signal (cos(Ω₂t)) modulated at the second pulse (Ω₂) being synchronized by the clock, the electronic system (75, 76) being adapted to amplitude and phase-tune the second electrical signal (sin(Ω₂t)) modulated at the second pulse (Ω₂) with respect to the first electrical signal (sin(Ωt), sin(Ω₁t)) modulated at the first pulse (Ω, Ω₁) and to form a first electrical signal double-modulated at the first pulse (Ω, Ω₁) and at the second pulse (Ω2), the electronic system (75, 76) being adapted to amplitude and phase-tune the other electrical signal (cos(Ω₂t)) modulated at the second pulse (Ω2) with respect to the other electrical signal (cos(Ωt), cos(Ω₁t)) modulated at the first pulse (Ω, Ω₁) and to form another electrical signal double-modulated at the first pulse (Ω, Ω₁) and the second pulse (Ω2), and the electronic system (75, 76) being adapted to electrical phase-shift-tune the first double-modulated electrical signal with respect to the other double-modulated electrical signal, and the electronic system (75, 76) being adapted to simultaneously apply the first double-modulated electrical signal to the first high-frequency electrode (62a) and, respectively, the other double-modulated electrical signal to the other high-frequency electrode (62b), and the electronic system (75, 76) being adapted to switch and tune the second pulse (Ω2) in a microwave spectral range extending over at most 100 gigahertz so as to frequency-switch the output laser beam simultaneously to the first optical frequency shifted by the first pulse (Ω, Ω1) with respect to the initial optical frequency (ωo) and to a second optical frequency shifted by the second pulse (Ω2) with respect to the initial optical frequency (wo), the first shifted optical frequency and the second shifted optical frequency being shifted in the same direction with respect to the initial optical frequency (wo), while attenuating the output laser beam at the other harmonics of the second pulse (Ω2) with respect to the initial optical frequency (ωo).

3. The device according to claim 1, wherein the electronic system (75, 76) includes a radiofrequency electronic synthesizer (75) adapted to generate an electrical signal modulated at the first pulse (Ω, Ω₁) and a hybrid coupler (76) having a first output channel (77) and a second output channel (78), the first output channel (77) being electrically connected to the first high-frequency electrode (62a), and respectively, the second output channel (78) being electrically connected to the other high-frequency electrode (62b), the hybrid coupler (76) being adapted to receive the electrical signal modulated at the first pulse (Ω, Ω₁) and to generate the first electrical signal (sin(Ωt), sin(Ω₁t)) modulated at the first pulse (Ω, Ω₁) on the first output channel (77) and, respectively, the other electrical signal (cos(Ωt), cos(Q₁t)) modulated at the first pulse (Ω, Ω₁), in phase-quadrature, on the second output channel (78).

4. The device according to claims 2 and 3, wherein the radiofrequency electronic synthesizer (75) is adapted to generate an electrical signal modulated at the second pulse (Ω₂), the hybrid coupler (76) being adapted to receive the electrical signal modulated at the second pulse (Ω₂) and to generate the second electrical signal modulated (sin(Ω₂t)) at the second pulse (Ω₂) on the first output channel (77) and, respectively, the other electrical signal (cos(Ω₂t)) modulated at the second pulse (Ω₂), in phase-quadrature, on the second output channel (78).

5. The device according to any one of claims 1 to 4, further comprising a non-linear optical component (48) arranged to receive the output laser beam at the first optical frequency shifted by the first pulse (Ω1) with respect to the initial optical frequency (wo) and/or at the second optical frequency shifted by the second pulse (Ω2) with respect to the initial optical frequency (wo), the non-linear optical component (48) being adapted to generate a laser beam at an optical frequency equal to twice the first shifted optical frequency, at an optical frequency equal to twice the second shifted optical frequency and/or, respectively, at an optical frequency equal to the sum of the first shifted optical frequency and of the second shifted optical frequency.

6. The device according to any one of claims 1 to 5, further comprising an optical switch (80), the optical switch (80) having an input path (81) and a plurality of output paths (82, 83, 84, 85), the optical switch (80) being adapted to receive on the input path and to direct to one of the output paths the output laser beam at the first optical frequency shifted by the first pulse (Ω1) with respect to the initial optical frequency (wo), the output laser beam at the second optical frequency shifted by the second pulse (Ω2) with respect to the initial optical frequency (wo), the laser beam at the optical frequency equal to twice the first shifted optical frequency, the laser beam at the optical frequency equal to twice the second shifted optical frequency and/or, respectively, the laser beam at the optical frequency equal to the sum of the first shifted optical frequency and of the second shifted optical frequency.

7. The device according to any one of claims 1 to 6, comprising an electronic feedback loop comprising a photodetector (39), an electrical source (43) and a signal mixer (42), the photodetector (39) being adapted to measure a signal of absorption by the chemical species (7, 11, 15, 16) of the output laser beam at the first shifted optical frequency, at the second shifted optical frequency, of the laser beam at the optical frequency equal to twice the first shifted optical frequency, of the laser beam at the optical frequency equal to twice the second shifted optical frequency and/or, respectively, of the laser beam at the optical frequency equal to the sum of the first shifted optical frequency and of the second shifted optical frequency, the electrical source (43) being adapted to generate a low-frequency signal and the signal mixer (42) being adapted to mix the absorption signal and the low-frequency signal to form an error signal.

8. The device according to claim 7, wherein the electronic feedback loop is configured to intermittently apply the error signal to the laser source (19) so as to tune the initial optical frequency (wo) to a reference hyperfine energy transition of the chemical species.

9. The device according to claim 8, wherein the electronic feedback loop is configured to intermittently apply the error signal to the electronic system (75, 76) so as to tune the first pulse (Ω, Ω₁) and/or the second pulse (Ω₂).

10. The device according to any one of claims 1 to 9, wherein the laser source (19) comprises a semiconductor laser or a fibre-optic laser.

11. A cold-atom and laser-pulse interferometer comprising a device according to any one of claims 4 to 10, wherein the chemical species is consisted of atoms and wherein the radiofrequency electronic synthesizer (75) is adapted to switch the first pulse (Ω1) and the second pulse (Ω2) according to a predetermined sequence.

12. A hyperfine optical spectrometry apparatus comprising a device according to any one of claims 1 to 10, wherein the chemical species is consisted of atoms, ions or molecules, and comprising a detector adapted to measure a hyperfine energy transition of the chemical species by absorption, reflection or scattering of the frequency-shifted laser beam.

13. A method for interaction between a laser beam and a hyperfine energy transition of a chemical species comprising the following steps:
- confining the chemical species (7, 11, 15, 16) in a vacuum space (8),
- emitting a source laser beam at an initial optical frequency (wo),
- injecting the source laser beam to an input optical waveguide (57) of a single sideband electro-optic modulator (55),
- generating a first electrical signal (sin(Ωt), sin(Ω₁t)) modulated at a first pulse (Ω, Ω₁) synchronized to a clock and, respectively, another electrical signal (cos(Ωt), cos(Ω₁t)) modulated at the first pulse (Ω, Ω₁) synchronized to the clock, the first pulse (Ω, Ω₁) being switchable and tunable in a microwave spectral range extending over at most 100 gigahertz,
- amplitude and phase-tuning the first modulated electrical signal (sin(Ωt), sin(Ω₁t)) with respect to the other electrical signal (cos(Ωt), cos(Ω₁t)) modulated at the first pulse (Ω, Ω₁),
- simultaneously applying the first electrical signal (sin(Ωt), sin(Ω₁t)) modulated at the first pulse (Ω, Ω₁) to a first high-frequency electrode (62a) of the electro-optic modulator (55) and, respectively, the other electrical signal (cos(Ωt), cos(Ω₁t)) modulated at the first pulse (Ω, Ω₁) to another high-frequency electrode (62b) of the electro-optic modulator (55) so as to selectively generate, on an output optical waveguide (157) of the electro-optic modulator (55), an output laser beam at a first optical frequency shifted by the first pulse (Ω, Ω₁) with respect to the initial optical frequency (wo) while attenuating the laser beam at the initial optical frequency (wo) and at the other harmonic frequencies of the first pulse (Ω, Ω₁) with respect to the initial optical frequency (wo), and
- optically amplifying (47, 87) the output laser beam to generate a laser beam amplified at the first shifted optical frequency (wo+Ω, ωo+Ω₁, ωo-Ω, ωo-Ω₁), and
- transmitting the first laser beam amplified at the first optical frequency shifted (wo+Ω, ωo+Ω₁) towards the chemical species (7, 11, 15, 16), for it to interact with a hyperfine energy transition of the chemical species (7, 11, 15, 16).

14. The method according to claim 13, further comprising the following steps:
- generating a second electrical signal (sin(Ω₂t)) modulated at a second pulse (Ω₂) synchronized to the clock and, respectively, another electrical signal (cos(Ω₂t)) modulated at the second pulse (Ω₂), synchronized to the clock, the second pulse (Ω₂) being switchable and tunable in a microwave spectral range extending over at most 100 gigahertz,
- amplitude and phase-tuning the second electrical signal (sin(Ω₂t)) modulated at the second pulse (Ω₂) with respect to the first electrical signal (sin(Ωt), sin(Ω₁t)) modulated at the first pulse (Ω, Ω1) to form a first electrical signal double-modulated at the first pulse (Ω, Ω1) and the second pulse (Ω₂), and amplitude and phase-tuning the other electrical signal modulated (cos(Ω₂t)) at the second pulse (Ω₂) with respect to the other electrical signal (cos(Ωt), cos(Ω₁t)) modulated at the first pulse (Ω, Ω1) to form another electrical signal double-modulated at the first pulse (Ω, Ω1) and the second pulse (Ω₂),
- electrical phase-tuning the first double-modulated electrical signal with respect to the other double-modulated electrical signal,
- simultaneously applying the first double-modulated electrical signal to the first high-frequency electrical signal (62a) of the electro-optic modulator (55) and, respectively, the other double-modulated electrical signal to the other high-frequency electrode (62b) of the electro-optic modulator (55) so as to generate on the output optical waveguide (157) of the electro-optic modulator (55), an output laser beam simultaneously switched to the first optical frequency shifted by the first pulse (Ω, Ω1) with respect to the initial optical frequency (wo) and to a second optical frequency shifted by the second pulse (Ω2) with respect to the initial optical frequency (wo), the first shifted optical frequency and the second shifted optical frequency being shifted in the same direction with respect to the initial optical frequency (ωo),
- optically amplifying (47, 87) the output laser beam to generate a laser beam simultaneously amplified at the first shifted optical frequency (ωo+Ω, ωο+Ω₁, ωo-Ω, ωο-Ω₁) and at the second shifted optical frequency, and
- transmitting the laser beam simultaneously amplified at the first shifted optical frequency (wo+Ω, ωο+Ω₁, ωo-Ω, ωο-Ω₁) and at the second shifted optical frequency towards the chemical species (7, 11, 15, 16).
